# EUROPEAN PATENT SPECIFICATION

(11) **EP 3 107 160 B1**
(45) Date of publication and mention of the grant of the patent: **20.10.2021**
(21) Application number: 15749399.0
(22) Date of filing: 06.02.2015
(51) Int. Cl.: H01S 5/026, H01S 5/0625, H01S 5/10, H01S 5/227, H01S 5/343, H01S 5/50

(54) **INTEGRATED SEMICONDUCTOR LASER ELEMENT AND SEMICONDUCTOR LASER MODULE**
INTEGRIERTES HALBLEITERLASERELEMENT UND HALBLEITERLASERMODUL
ÉLÉMENT LASER À SEMI-CONDUCTEURS INTÉGRÉS ET MODULE LASER À SEMI-CONDUCTEURS

(30) Priority: 13.02.2014 JP 2014025964
(43) Date of publication of application: 21.12.2016
(73) Proprietor: Furukawa Electric Co., Ltd., Tokyo 100-8322 (JP)
(72) Inventor: KIYOTA, Kazuaki, Tokyo 100-8322 (JP); KOBAYASHI, Go, Tokyo 100-8322 (JP)
(74) Representative: SSM Sandmair
(86) International application number: PCT/JP2015/053366
(87) International publication number: WO 2015/122367

(56) References cited:
- JP-A- H0 358 490
- JP-A- 2004 349 692
- JP-A- 2011 035 060
- JP-A- 2012 169 499
- JP-A- 2012 186 419
- JP-A- 2013 061 632
- JP-A- 2013 061 632
- JP-A- 2013 102 003
- JP-A- 2013 251 424
- US-A1- 2002 131 461
- US-A1- 2005 244 994
- US-A1- 2008 291 952
- None

## Description

### Field

The present invention relates to integrated semiconductor laser devices and semiconductor laser modules.

### Background

An integrated semiconductor laser device is disclosed as a tunable light source for dense wavelength division multiplexing (DWDM) optical communications, for example (see Patent Literature 1).

This integrated semiconductor laser device has a plurality of distributed feedback (DFB) laser stripes, a plurality of optical waveguides, a multi-mode interferometer (MMI) optical coupler, and a semiconductor optical amplifier integrated on a single substrate. The optical waveguides guide output light from the DFB laser stripes. The MMI optical coupler passes light guided through the optical waveguides to output. The semiconductor optical amplifier amplifies light output from the MMI optical coupler to output.

The integrated semiconductor laser device is used as a Lunable laser by selecting one of the plurality of DFB laser stripes with different wavelengths to perform wavelength coarse adjustment, and further, controlling the temperature of the integrated semiconductor laser device to perform wavelength fine adjustment. The tunable laser is used as a signal light source for optical communications to obtain desired channels for wavelength multiplexing communications.

In recent years, multilevel modulation schemes have been used to increase communication rates in optical communications. As a multilevel modulation scheme, a coherent communication scheme based on phase-shift keying (PSK) is used. Coherent communications like this need a local oscillation light source at the receiving end in addition to a signal light source at the transmitting end.

Coherent communications, in which information is put on phases of light, thus require a signal light source and a local oscillation light source to be small in phase fluctuations. As a characteristic value serving as an index of the magnitude of phase fluctuations, a spectral linewidth of laser light is used. The narrower the spectral linewidth, the smaller the phase fluctuations. It is required that the spectral linewidth of a light source used in coherent communications be 500 kHz or less in quaternary PSK (QPSK) with a communications modulation rate of 25 Gbaud, for example. Further, for further increased levels in the future, it is required that the spectral linewidth of a light source used in coherent communications be 300 kHz or less. These requirements to the characteristic value change as the multilevel modulation schemes are sophisticated. It is expected that a modulation scheme with a higher degree of level increase such as quadrature amplitude modulation (QAM) will require a still narrower spectral linewidth of 100 kHz or less.

Further, in recent years, there have been increasing requests to increase the intensity of laser light output from signal light sources. Increasing the intensity of laser light provides an advantage that an amplifier installed after a transmitter can be omitted, or by splitting laser light, a single light source can be used for both signal light and local oscillation light, or the like. As optical intensity with which such an advantage can be obtained, an output optical intensity of 40 mW or more, for example, is required.

Thus, in recent years, output laser light with a narrow spectral linewidth and high intensity has been demanded of tunable lasers used as light sources.

Here, it is known that in order to narrow the spectral linewidth of laser light, it is effective to lengthen DFB laser stripes. It is also known that in order to increase the intensity of laser light output, it is effective to lengthen a semiconductor optical amplifier.

As another method for narrowing the spectral linewidth of laser light, it is described in Non Patent Literature 1, for example, that the larger the number of quantum wells in an active layer of semiconductor lasers or a semiconductor optical amplifier, the smaller the linewidth enhancement factor, resulting in a narrower spectral linewidth.

As another method for increasing the optical intensity, Patent Literature 2 discloses an integrated semiconductor laser device in which the thickness of an active layer of a semiconductor optical amplifier is made smaller than the thickness of an active layer of semiconductor lasers to reduce the factor of optical confinement to the active layer of the semiconductor optical amplifier to increase saturation optical power intensity.

Additionally, an example of an integrated semiconductor laser device can be found in US 2005/244994 A1. The device comprises a semiconductor laser, and a semiconductor optical amplifier configured to amplify output laser light of the semiconductor laser. Furthermore, an optical waveguide is optically connected to the semiconductor laser and configured to guide the output laser light of the semiconductor laser. The semiconductor laser and the semiconductor optical amplifier both are integrated on a surface of a substrate. The semiconductor laser includes a first active layer, the semiconductor optical amplifier includes a second active layer and the first active layer and the second active layer each include a multiple quantum well structure.

### Citation List

### Patent Literatures

Patent Literature 1: Japanese Patent Application Laid-open No. 2003-258368
Patent Literature 2: Japanese Patent Application Laid-open No. 2008-205113

### Non Patent Literature

Non Patent Literature 1: S. H. Cho, et. al. IEEE PHOTONICS TECHNOLOGY LETTERS, VOL. 9, NO. 8, pp. 1081,

### Summary

### Technical Problem

However, it has been difficult to fulfill at the same time both narrowing the spectral linewidth and increasing the intensity of laser light required of signal light sources in recent years.

The present invention has been made in view of the above, and has an object of providing an integrated semiconductor laser device and a semiconductor laser module whose output laser light has a narrow spectral linewidth and high intensity.

### Solution to Problem

To solve the above-described problem and achieve the object, an integrated semiconductor laser device according to the present invention is defined in claim 1.

In the integrated semiconductor laser device according to one aspect of the present invention, the number of quantum wells in the second active layer is five or more.

Embodiments of the present invention are defined in the dependent claims. These embodiments relate to aspects of the present invention given disclosed below.

In an integrated semiconductor laser device according to one aspect of the present invention, the number of quantum wells in the first active layer is five or less.

In the integrated semiconductor laser device according to one aspect of the present invention, the second active layer has a longer wavelength corresponding to bandgap energy than the first active layer.

The integrated semiconductor laser device according to one aspect of the present invention includes an optical loss unit disposed between the semiconductor laser and the semiconductor optical amplifier, and configured to cause a loss to optical intensity of output laser light of the semiconductor laser to be input to the semiconductor optical amplifier.

The integrated semiconductor laser device according to one aspect of the present invention includes: a plurality of the semiconductor lasers that are configured to be different from each other in wavelengths of output laser light; and an optical coupler configured to couple the output laser light of the plurality of semiconductor lasers.

In the integrated semiconductor laser device according to one aspect of the present invention, the semiconductor laser has a length of 1000 µm or more in an optical cavity length direction.

In the integrated semiconductor laser device according to one aspect of the present invention, the semiconductor laser and the semiconductor optical amplifier are integrated on the substrate made of InP, and the first active layer and the second active layer contain an InGaAsP-based material.

In the integrated semiconductor laser device according to one aspect of the present invention, the semiconductor laser and the semiconductor optical amplifier are integrated on the substrate made of InP, the first active layer contains an InGaAsP-based material, and the second active layer contains an AlGaInAs-based material.

In the integrated semiconductor laser device according to one aspect of the present invention, the semiconductor laser has a distributed feedback laser section and a distributed Bragg reflection section, in the distributed feedback laser section, the first active layer is continuous over an optical cavity length direction, and a diffraction grating layer is disposed in the vicinity of the first active layer along the first active layer, and in the distributed Bragg reflection section, the first active layer is disposed discretely and periodically to form a diffraction grating.

A semiconductor laser module according to one aspect of the present invention includes the integrated semiconductor laser device according to one aspect of the present invention.

### Advantageous Effects of Invention

The present invention can provide an integrated semiconductor laser device and a semiconductor laser module whose output laser light has a narrow spectral linewidth and high intensity.

### Brief Description of Drawings

FIG. 1 is a schematic plan view of an integrated semiconductor laser device according to a first embodiment of the present invention.
FIG. 2 is a cross-sectional view of a principal part along line A-A of the integrated semiconductor laser device illustrated in FIG. 1.
FIG. 3 is a cross-sectional view of a principal part along line B-B of the integrated semiconductor laser device illustrated in FIG. 1.
FIG. 4 is a cross-sectional view of a principal part along line C-C of the integrated semiconductor laser device illustrated in FIG. 1.
FIG. 5 is a cross-sectional view of a principal part along line D-D of the integrated semiconductor laser device illustrated in FIG. 1.
FIG. 6 is a graph showing the relationship between the spectral linewidth of output laser light of integrated semiconductor laser devices and the number of quantum wells.
FIG. 7 is a graph showing the relationship between the optical intensity of output laser light of integrated semiconductor laser devices and the number of quantum wells.
FIG. 8 is a graph showing the results of calculating the ratio between the intensity of laser light and ASE optical intensity contained in output light of semiconductor lasers.
FIG. 9 is a diagram explaining a method of manufacturing the integrated semiconductor laser device illustrated in FIG. 1.
FIG. 10 is a diagram explaining the method of manufacturing the integrated semiconductor laser device illustrated in FIG. 1.
FIG. 11 is a diagram explaining the method of manufacturing the integrated semiconductor laser device illustrated in FIG. 1.
FIG. 12 is a diagram explaining the method of manufacturing the integrated semiconductor laser device illustrated in FIG. 1.
FIG. 13 is a diagram explaining the method of manufacturing the integrated semiconductor laser device illustrated in FIG. 1.
FIG. 14 is a diagram explaining the method of manufacturing the integrated semiconductor laser device illustrated in FIG. 1.
FIG. 15 is a diagram explaining the method of manufacturing the integrated semiconductor laser device illustrated in FIG. 1.
FIG. 16 is a schematic plan view of an integrated semiconductor laser device according to a second embodiment of the present invention.
FIG. 17 is a cross-sectional view of a principal part along line H-H of the integrated semiconductor laser device illustrated in FIG. 16.
FIG. 18 is a diagram explaining a method of manufacturing the integrated semiconductor laser device illustrated in FIG. 16.
FIG. 19 is a diagram explaining the method of manufacturing the integrated semiconductor laser device illustrated in FIG. 16.

### Description of Embodiments

Hereinafter, with reference to the drawings, embodiments of an integrated semiconductor laser device and a semiconductor laser module according to the present invention will be described. The present invention is not limited to the embodiments. In descriptions of the drawings, the same or corresponding elements are denoted by the same reference numerals as appropriate. The drawings are schematic, and it should be noted that the dimensional relationships between elements, the ratios between elements, and the like may be different from those in reality. The drawings may include portions where their dimensional relationships or ratios are different between them.

### (First Embodiment)

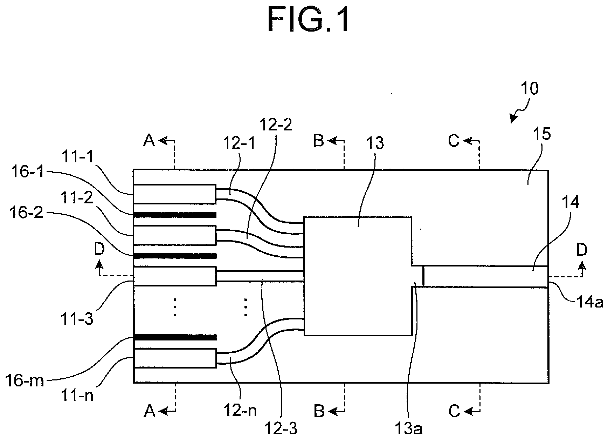

First, an integrated semiconductor laser device according to a first embodiment of the present invention will be described. FIG. 1 is a schematic plan view of the integrated semiconductor laser device according to the first embodiment of the present invention. As illustrated in FIG. 1, an integrated semiconductor laser device 10 according to the first embodiment is configured as an integrated semiconductor laser device. The integrated semiconductor laser device 10 has a structure in which a plurality of DFB laser stripes 11-1 to 11-n (n is an integer of two or more), semiconductor lasers to output laser light, a plurality of optical waveguides 12-1 to 12-n, an MMI optical coupler 13, an optical coupler, and a semiconductor optical amplifier 14 to amplify output laser light of the DFB laser stripes 11-1 to 11-n are integrated on a single semiconductor substrate, and an embedding portion 15 is formed around them. Trenches 16-1 to 16-m (m = n - 1) are provided between the DFB laser stripes 11-1 to 11-n to electrically separate the DFB laser stripes. Although a form having the plurality of DFB laser stripes 11 is herein described, the number of the DFB laser stripes 11 may be one, in which case trenches are unnecessary.

The DFB laser stripes 11-1 to 11-n are each an edge emitting laser having a stripe-shaped embedded structure of a width of 1.3 to 2.5 µm and a length of 1200 µm, and are formed with a pitch of 25 µm in a lateral direction at one end opposite to an output end 14a on the optical power side of the integrated semiconductor laser device 10. The pitch of the DFB laser stripes is designed to be small within a range of accuracy of manufacturing trenches and electrodes.

The DFB laser stripes 11-1 to 11-n are configured so that the wavelengths of output laser light are different in a range of the 1550 nm band (e.g. 1530 nm to 1570 nm) by making the pitches of diffraction gratings provided to the DFB laser stripes different from each other. The laser emission wavelengths of the DFB laser stripes 11-1 to 11-n can be adjusted by changing the set temperature of the integrated semiconductor laser device 10. That is, the integrated semiconductor laser device 10 provides a wide wavelength-variable range by switching among the DFB laser stripes to be driven and temperature control. The DFB laser stripes are supplied with a constant current from outside, thereby outputting continuous light, or alternatively may be supplied with a modulated current from outside, thereby outputting modulated signal light.

It is effective that the threshold gain of the DFB laser stripes 11-1 to 11-n is reduced in order to narrow the spectral linewidth of output laser light of the integrated semiconductor laser device 10. Threshold gain is proportional to the square of a coupling factor, and is inversely proportional to the cube of a cavity length, and thus is inversely proportional to the cavity length even when the product of the coupling factor and the cavity length is fixed. Therefore, threshold gain can be reduced by increasing a cavity length. Thus, the DFB laser stripes 11-1 to 11-n desirably have a long cavity length in order to narrow the spectrum linewidth of output laser light of the integrated semiconductor laser device 10. Specifically, the optical cavity length of the DFB laser stripes 11-1 to 11-n is preferably 1000 µm or more.

The optical waveguides 12-1 to 12-n are formed between the DFB laser stripes 11-1 to 11-n and the MMI optical coupler 13 to optically connect the DFB laser stripes 11-1 to 11-n and the MMI optical coupler 13.

The semiconductor optical amplifier 14 is connected to an output port 13a of the MMI optical coupler 13. The semiconductor optical amplifier 14 has a stripe-shaped embedded structure of a width of 1.3 µm to 4.0 µm and a length of 1500 µm (500 µm to 2000 µm). The semiconductor optical amplifier 14 may have a flared structure in which the stripe width becomes wider as it gets closer to the output end 14a.

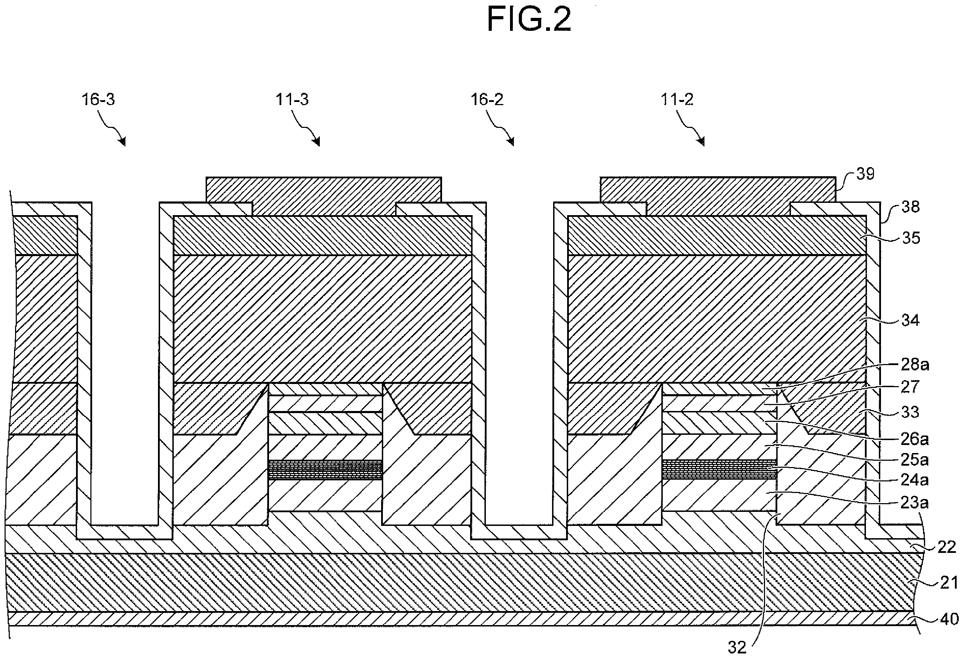

FIGS. 2, 3 and 4 are a cross-sectional view of a principal part along line A-A, a cross section of DFB laser stripes, a cross-sectional view of a principal part along line B-B, a cross section of the MMI optical coupler 13, and a cross-sectional view of a principal part along line C-C, a cross section of the semiconductor optical amplifier 14 in the integrated semiconductor laser device 10, respectively.

As illustrated in FIG. 2, the DFB laser stripes 11-2, 11-3 have a structure in which an n-type InP buffer layer 22 also serving as a lower cladding layer, a lower InGaAsP-SCH layer 23a, an active layer 24a, a first active layer, an upper InGaAsP-SCH layer 25a, an InP spacer layer 26a, an InGaAsP grating layer 27 formed with a diffraction grating, and a p-type InP cladding layer 28a are stacked successively on an n-type InP substrate 21. Mesa structures are formed from the p-type InP cladding layer 28a to a depth reaching halfway through the n-type InP buffer layer 22 to constitute the DFB laser stripes 11-2, 11-3. Both lateral sides of the mesa structures are embedded by a stacked structure of a p-type InP current blocking layer 32 and an n-type current blocking layer 33 that constitute the embedding portion 15.

The DFB laser stripes 11-2, 11-3 further include a p-type InP cladding layer 34 and an InGaAs contact layer 35 formed successively on the p-type InP cladding layer 28a and the n-type current blocking layer 33. The trenches 16-2, 16-3 are formed from the InGaAs contact layer 35 to a depth reaching halfway through the n-type InP buffer layer 22. An SiN protective film 38 is formed to cover the surface of the InGaAs contact layer 35 and the inner surfaces of the trenches 16-2, 16-3. Openings not covered by the SiN protective film 38 are formed in positions corresponding to those of the DFB laser stripes 11-2, 11-3 on the top surface of the InGaAs contact layer 35. p-side electrodes 39 are formed to contact the InGaAs contact layer 35 at the openings. In FIG. 1, descriptions of the p-side electrodes 39 are omitted. The integrated semiconductor laser device 10 further includes an n-side electrode 40 formed on the rear surface of the n-type InP substrate 21. The DFB laser stripes 11-1 to 11-n all have the same structure as the DFB laser stripes 11-2, 11-3.

Here, the active layer 24a, and the lower InGaAsP-SCH layer 23a, the upper InGaAsP-SCH layer 25a, the n-type InP buffer layer 22, and the p-type InP cladding layers 28a, 34 sandwiching the active layer 24a from above and below constitute a waveguide structure.

The active layer 24a has a multiple quantum well active layer made of InGaAsP, in which the thickness of a quantum well layer is 6 nm, and the number of quantum wells is four. The total thickness of the lower InGaAsP-SCH layer 23a, the active layer 24a, and the upper InGaAsP-SCH layer 25a is 145 nm. The sum of the factors of optical confinement to the quantum wells is calculated as 3.0%.

It is suitable to select the thickness of a quantum well layer in a range of 3.5 nm to 7 nm to sufficiently use a quantum effect. In order to set the spectral linewidth to 300 kHz or less, it is preferable to set the number of quantum wells in an active layer of a semiconductor laser to five or less, and more preferably to four or less. However, a too small number of quantum wells results in an increased amount of gain borne by a single well, degrading the temperature characteristics. Thus it is preferable to set the number of quantum wells to three or more.

Here, an optical confinement factor is the rate of optical intensity contained in an active layer, of the intensity of light guided by a waveguide structure including the active layer. When an active layer has a multiple quantum well structure as in the present embodiment, the optical confinement factor shall be calculated with only quantum well layers as the active layer, excluding barrier layers and SCH layers.

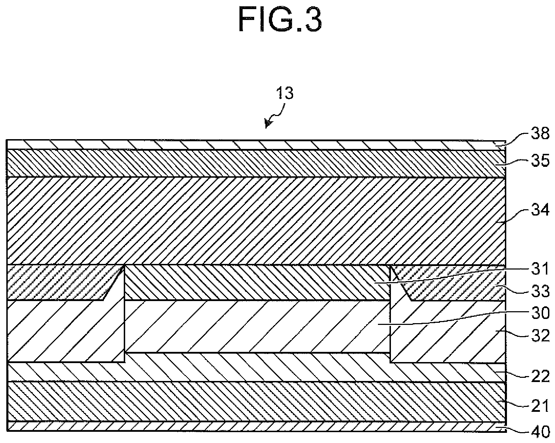

As illustrated in FIG. 3, the MMI optical coupler 13 has a structure in which the n-type InP buffer layer 22, an InGaAsP core layer 30, and an i-type InP layer 31 are staked successively on the n-type InP substrate 21. The composition of InGaAsP constituting the InGaAsP core layer 30 is set so that its bandgap wavelength is shorter than the laser emission wavelengths of the DFB laser stripes 11-1 to 11-n. A mesa structure is formed from the i-type InP layer 31 to a depth reaching halfway through the n-type InP buffer layer 22 to constitute the MMI optical coupler 13. Both lateral sides of the mesa structure are embedded by a stacked structure of the p-type InP current blocking layer 32 and the n-type current blocking layer 33.

The MMI optical coupler 13 further includes the p-type InP cladding layer 34, the InGaAs contact layer 35, and the SiN protective film 38 formed successively on the i-type InP layer 31 and the n-type current blocking layer 33. The SiN protective film 38 is formed to cover the entire top surface of the InGaAs contact layer 35.

The optical waveguides 12-1 to 12-n each also have a structure similar to that of the MMI optical coupler 13. However, in the MMI optical coupler 13, the core width (mesa width) of the InGaAsP core layer 30 is set to function as the MMI optical coupler 13. In contrast, in the optical waveguides 12-1 to 12-n, the core width (mesa width) of the corresponding InGaAsP core layer is set to propagate in single mode light of laser emission wavelengths of the DFB laser stripes 11-1 to 11-n.

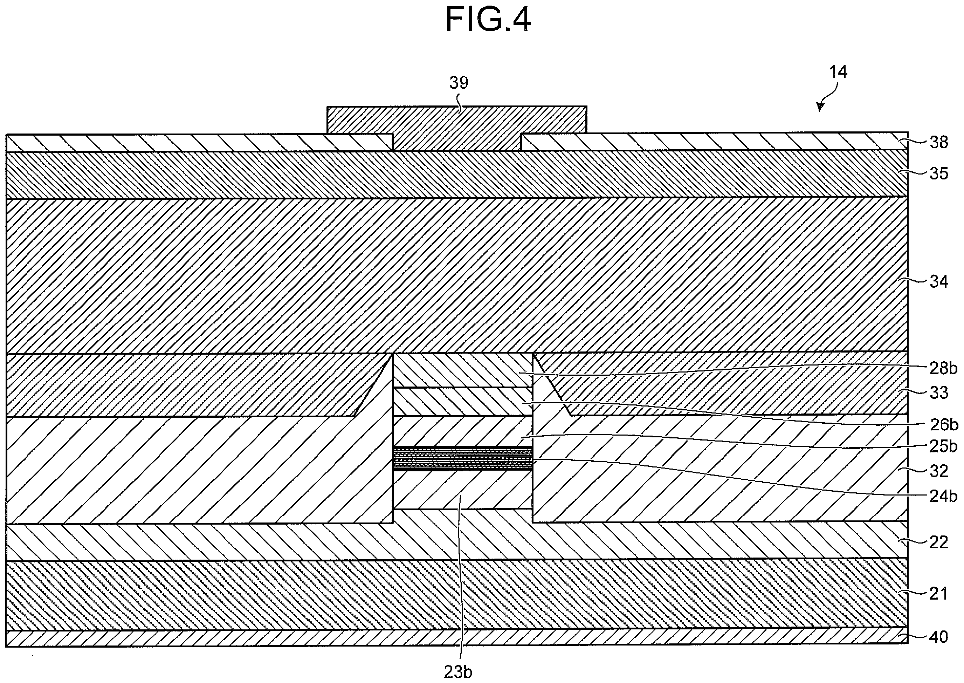

As illustrated in FIG. 4, the semiconductor optical amplifier 14 has a structure in which the n-type InP buffer layer 22, a lower InGaAsP-SCH layer 23b, an active layer 24b, a second active layer, an upper InGaAsP-SCH layer 25b, an InP spacer layer 26b, and a p-type InP cladding layer 28b are stacked successively on the n-type InP substrate 21. A mesa structure is formed from the p-type InP cladding layer 28b to a depth reaching halfway through the n-type InP buffer layer 22 to constitute the semiconductor optical amplifier 14. Both lateral sides of the mesa structure are embedded by a stacked structure of the p-type InP current blocking layer 32 and the n-type current blocking layer 33.

The semiconductor optical amplifier 14 further includes the p-type InP cladding layer 34, the InGaAs contact layer 35, and the SiN protective film 38 formed successively on the p-type InP cladding layer 28b and the n-type current blocking layer 33. An opening not covered by the SiN protective film 38 is formed on the top surface of the InGaAs contact layer 35 in a position corresponding to that of the mesa structure. A p-side electrode 39 is formed to contact the InGaAs contact layer 35 at the opening and cover the entire opening.

Here, the active layer 24b, and the lower InGaAsP-SCH layer 23b, the upper InGaAsP-SCH layer 25b, the n-type InP buffer layer 22, and the p-type InP cladding layers 28b, 34 sandwiching the active layer 24b from above and below constitute a waveguide structure.

The active layer 24b has a multiple quantum well active layer made of InGaAsP, in which the thickness of a quantum well layer is 6 nm, and the number of quantum wells is six. At this time, the total thickness of the lower InGaAsP-SCH layer 23b, the active layer 24b, and the upper InGaAsP-SCH layer 25b is 175 nm. The sum of the factors of optical confinement to the quantum wells is calculated as 5.4%.

It is suitable to select the thickness of a quantum well layer in a range of 3.5 nm to 7 nm to sufficiently use a quantum effect. In order to set the optical intensity of output laser light of the integrated semiconductor laser device to 35 mW or more, and more preferably, 40 mW or more, it is preferable to set the number of quantum wells in an active layer of a semiconductor laser to five or more, and more preferably to six or more. In terms of uniform injection, it is preferable to set the number of quantum wells to eight or less.

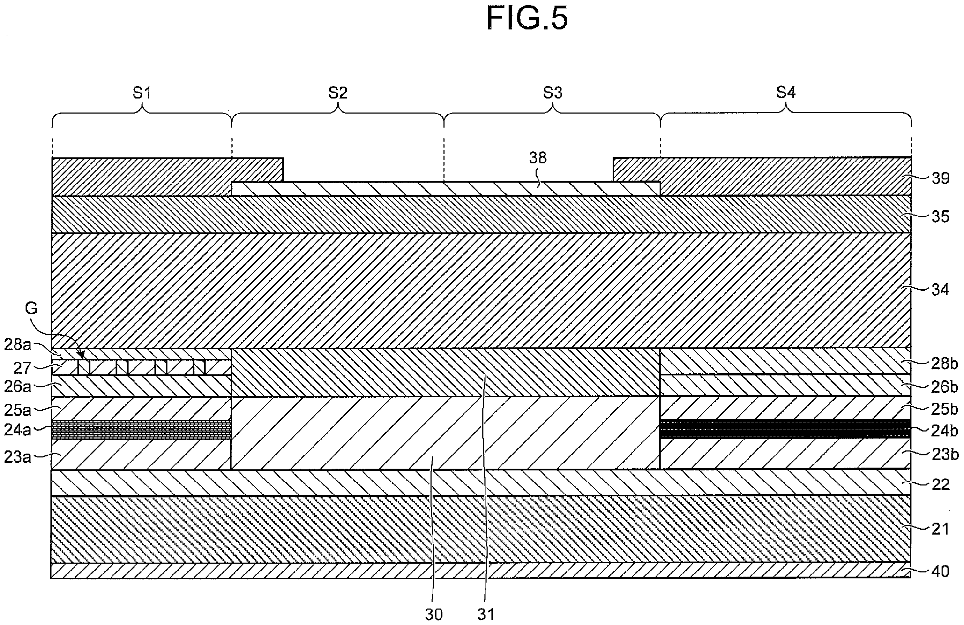

Next, FIG. 5 is a cross-sectional view of a principal part along line D-D of the integrated semiconductor laser device illustrated in FIG. 1. In FIG. 5, a region S1 represents the DFB laser stripe, a region S2 the optical waveguide, a region S3 the MMI optical coupler 13, and a region S4 the semiconductor optical amplifier 14. As illustrated in FIG. 5, the DFB laser stripes 11-1 to 11-n, the optical waveguides 12-1 to 12-n, the MMI optical coupler 13, and the semiconductor optical amplifier 14 are formed on the same n-type InP substrate 21.

The i-type InP layer 31, the p-type InP cladding layer 34, and the n-type InP buffer layer 22 sandwiching the InGaAsP core layer 30 from above and below constitute a waveguide structure.

Here, the active layer 24a of the DFB laser stripes 11-1 to 11-n and the active layer 24b of the semiconductor optical amplifier 14 are different in their configurations. The difference in configuration results in the factor of optical confinement to the active layer 24b of the semiconductor optical amplifier 14 greater than the factor of optical confinement to the active layer 24a of the DFB laser stripes 11-1 to 11-n.

Specifically, in the integrated semiconductor laser device 10 according to the first embodiment, the number of quantum wells in the active layer 24a of the DFB laser stripes 11-1 to 11-n, semiconductor lasers, is four, and the number of quantum wells in the active layer 24b of the semiconductor optical amplifier 14 is six, which is larger than the number of quantum wells in the active layer 24a. As a result, the factor of optical confinement to the active layer 24b of the semiconductor optical amplifier 14 (5.4%) is greater than the factor of optical confinement to the active layer 24a of the DFB laser stripes 11-1 to 11-n (3.0%) .

As a result, as described below, the integrated semiconductor laser device 10 can fulfill both narrowing the spectral linewidth and increasing the intensity of output laser light at the same time.

The ratio of the factor of optical confinement to the quantum wells of the DFB laser stripes 11-1 to 11-n and that of the semiconductor optical amplifier 14 is 1.8 times. It is suitable to set the ratio of the optical confinement factors to 1.2 times or more, for example, since it can provide prominent effects of narrowing the spectral linewidth and increasing the intensity of laser light. The thicknesses of the barrier layers between the multiple quantum wells in the active layers, the lower InGaAsP-SCH layers, and the upper InGaAsP-SCH layers can be selected as appropriate for fine adjustment of the optical confinement factors. The thickness of the barrier layers between the multiple quantum wells in the active layers is about 10 nm (5 to 15 nm), for example, and the thickness of the lower InGaAsP-SCH layers and the upper InGaAsP-SCH layers is about several tens of nanometers (30 to 150 nm), for example.

Next, the operation of the integrated semiconductor laser device 10 will be described. First, one DFB laser stripe selected from among the DFB laser stripes 11-1 to 11-n is driven. The driven DFB laser stripe outputs laser light. Since the trenches 16-1 to 16-m provide electrical separation between the DFB laser stripes 11-1 to 11-n, the separation resistance between the DFB laser stripes increases. This facilitates selecting and driving one of the DFB laser stripes 11-1 to 11-n.

Of the plurality of optical waveguides 12-1 to 12-n, the optical waveguide optically connected to the driven DFB laser stripe guides the laser light from the driven DFB laser stripe. The MMI optical coupler 13 passes the laser light guided through the optical waveguide and outputs it from the output port 13a. The semiconductor optical amplifier 14 amplifies the laser light output from the output port 13a, and outputs it from the output end 14a to the outside.

The output laser light of the DFB laser stripe is attenuated to an amount inversely proportional to the number of the DFB laser stripes in the MMI optical coupler 13. In the first embodiment, the number of the DFB laser stripes is n, and thus the output laser light of the MMI optical coupler 13 becomes about 1/n of the output laser light of the DFB laser stripe. Therefore, the semiconductor optical amplifier 14 compensates for the light loss of the output laser light from the driven DFB laser stripe due to the MMI optical coupler 13, and amplifies the laser light to be output from the output end 14a to desired optical intensity.

Here, details of a consideration made by the present inventors to contrive the configuration of the first embodiment will be described. In order to provide an integrated semiconductor laser device and a semiconductor laser module whose output laser light has a narrow spectral linewidth and high intensity, it is important to properly set the configurations of active layers of semiconductor lasers and a semiconductor optical amplifier.

It is known that the spectral linewidth of output laser light of a semiconductor laser theoretically depends on output optical intensity, a threshold gain, a linewidth enhancement factor, an internal loss, and others. These characteristic values can be adjusted by the cavity length and the configuration of an active layer of the semiconductor laser.

As described above, a semiconductor laser is preferably increased in cavity length to narrow the spectral linewidth.

However, increasing the cavity length causes a problem that the number of chips that can be taken from one wafer is reduced due to an increased device area. Simply increasing the cavity length has a limit. Therefore, it is necessary to optimize the configuration of an active layer of a semiconductor laser to further narrow the spectral linewidth.

As an important factor to narrow the spectral linewidth of an output laser light, there is a linewidth enhancement factor. The square of a linewidth enhancement factor contributes to the spectral linewidth. That is, a reduction in the linewidth enhancement factor can narrow the spectral linewidth.

The smaller the injected carrier density, the smaller the linewidth enhancement factor tends to become. From this perspective, in order to narrow the spectral linewidth, it is effective to increase the number of quantum wells so that the injected carrier density becomes smaller at a threshold value, increasing the confinement factor. For example, in Non Patent Literature 1, it is described that the larger the number of quantum wells, the smaller the linewidth enhancement factor.

However, in some cases, an increased number of quantum wells in a semiconductor laser does not result in a narrower spectral linewidth.

To confirm this, the present inventors actually produced a plurality of integrated semiconductor laser devices including semiconductor lasers different from each other in the number of quantum wells, and including optical waveguides, MMI optical couplers, and semiconductor optical amplifiers. Then, the relationship between the spectral linewidth of output laser light of the integrated semiconductor laser devices and the number of quantum wells was confirmed by experiments. The results are shown below. The semiconductor lasers have a cavity length of 1200 µm, and have the same configuration including a coupling factor, other than the number of quantum wells.

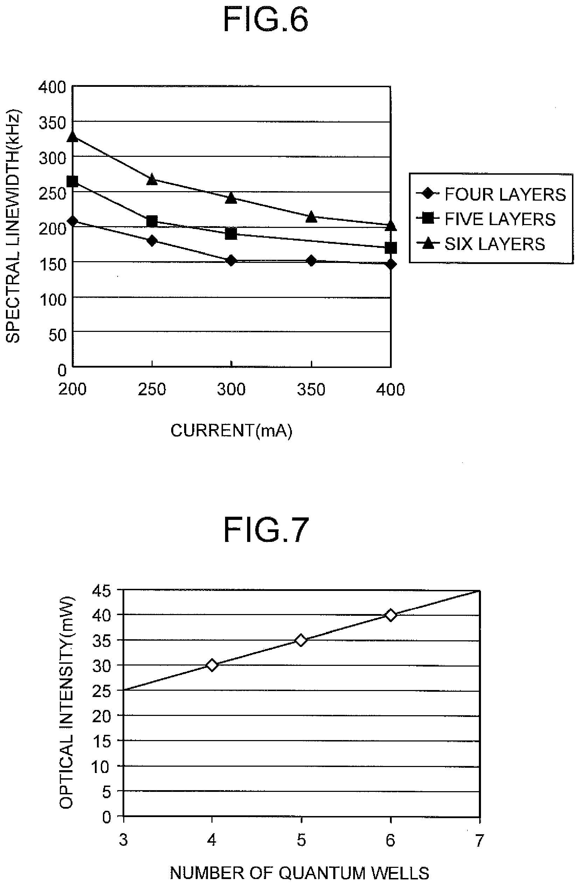

FIG. 6 is a graph showing the relationship between the spectral linewidth of output laser light of the integrated semiconductor laser devices and the number of quantum wells. As illustrated in FIG. 6, the smaller the number of quantum wells at any current value, the narrower the spectral linewidth of output laser light of the integrated semiconductor laser devices. The reason is estimated that in the 1550 nm band (1525 nm to 1610 nm), optical communications wavelengths, the spectral linewidth is affected by the internal loss more greatly than the linewidth enhancement factor. It is found that the smaller the number of quantum wells, the smaller the driving current to obtain output laser light of a desired spectral linewidth. That is, a semiconductor laser with a smaller number of quantum wells can provide output laser light of a narrower spectral linewidth with a low power consumption.

The semiconductor lasers with a small number of quantum wells in the first embodiment also achieves an effect of high external differential quantum efficiency, which provides semiconductor lasers with good luminous efficiency.

Next, the configuration of the active layer of the semiconductor optical amplifier will be described. In order to increase the intensity of output laser light of the integrated semiconductor laser device, it is important to optimize the length of the semiconductor optical amplifier in an optical waveguide direction and the configuration of the active layer.

When the length of the semiconductor optical amplifier is long, optical power is obtained even when the gain of the active layer per unit length is low. However, lengthening the semiconductor optical amplifier results in a reduction in the number of chips that can be taken from one wafer due to an increase in the device area, and an increase in current necessary for transparency with the area increase. Therefore, simply lengthening the semiconductor optical amplifier has a limit. Thus, it is necessary to increase the gain of the active layer.

In the integrated semiconductor laser device according to Patent Literature 2, the thickness of an active layer of a semiconductor optical amplifier is made smaller than the thickness of an active layer of semiconductor lasers to reduce the factor of optical confinement to the active layer to avoid gain saturation.

Here, gain saturation is a phenomenon in which linear output cannot be obtained with respect to input. Semiconductor optical amplifiers have a constant amplification factor on input power in a sufficiently small optical intensity region, but have a lower amplification factor on input power in a large optical intensity region. This is because stimulated emission for light amplification consumes carriers, making it impossible to maintain a carrier density to obtain a constant amplification factor. Thus gain saturation makes it impossible to obtain linearity between input power and output optical intensity, which becomes a major problem in amplifying modulated light signals temporally varying in input optical intensity. Therefore, reducing the amplification factor by reducing the factor of optical confinement to the active layer of the semiconductor optical amplifier can limit stimulated emission to some extent to prevent a reduction in carrier density even when input power is increased. This can prevent occurrence of gain saturation.

However, when continuous light is amplified instead of modulated signal light, linearity between input power and output optical intensity as in Patent Literature 2 is not necessary. Therefore, considering only amplification of continuous light, the active layer of the semiconductor optical amplifier can be optimized to achieve increased output of the integrated semiconductor laser device.

In order to efficiently increase the intensity of output laser light of the integrated semiconductor laser device, it is effective to increase the factor of optical confinement to the active layer of the semiconductor optical amplifier to increase gain. This is because increased gain facilitates stimulated emission, allowing more efficient conversion of electric energy to optical energy. The optical confinement factor can be increased by increasing the number of quantum wells as described above.

Here, a plurality of integrated semiconductor laser devices including semiconductor lasers, optical waveguides, MMI optical couplers, and semiconductor optical amplifiers different from each other in the number of quantum wells were actually produced to confirm the relationship between the optical intensity of output laser light of the integrated semiconductor laser devices and the number of quantum wells by experiments. In the experiments, the temperature of the integrated semiconductor laser devices is 55°C, and an injected current to the semiconductor optical amplifiers is 300 mA. The semiconductor optical amplifiers of the integrated semiconductor laser devices have a cavity length of 1500 µm, and have the same configuration other than the number of quantum wells. FIG. 7 is a graph showing the relationship between the optical intensity of output laser light of the integrated semiconductor laser devices and the number of quantum wells. As illustrated in FIG. 7, the larger the number of quantum wells, the larger the optical intensity of output laser light of the integrated semiconductor laser devices. That is, the experimental results show that a larger number of quantum wells in the active layer of the semiconductor optical amplifier and a greater factor of optical confinement to the active layer of the semiconductor optical amplifier provide output laser light of higher optical intensity.

A method of obtaining a higher gain by increasing the factor of optical confinement to the active layer of the semiconductor optical amplifier is highly effective particularly when the integrated semiconductor laser device is operated at a high temperature (e.g. 60°C or more). Generally, in integrated semiconductor laser devices, the gain of an active layer tends to be reduced at high temperatures, and optical power can be limited due to insufficient gain. On the other hand, the integrated semiconductor laser device in the present embodiment, in which the factor of optical confinement to the active layer of the semiconductor optical amplifier is high, provides sufficient optical power even at high temperatures. Operating an integrated semiconductor laser device at a high temperature can reduce the power consumption of a temperature control component, and thus can reduce the power consumption of the integrated semiconductor laser device as a whole. Therefore, a larger factor of optical confinement to an active layer of a semiconductor optical amplifier is preferable to increase the optical intensity of an integrated semiconductor laser device.

In order to prevent a reduction in efficiency of conversion from electric energy to optical energy in the vicinity of the output end of the semiconductor optical amplifier, the semiconductor optical amplifier may be formed in a flared structure in which the width is wider toward the output side.

As the active layer of the semiconductor optical amplifier, it is preferable to use an AlGaInAs active layer.

The use of an AlGaInAs active layer facilitates increasing gain and provides good high-temperature characteristics. Therefore, it is effective to use an AlGaInAs active layer particularly to operate a laser device at a high temperature. An integrated semiconductor laser device using an AlGaInAs active layer for an active layer of a semiconductor optical amplifier will be described below as a second embodiment.

As described above, an integrated semiconductor laser device that needs a narrow linewidth and high intensity at the same time in output laser light requires different characteristics between semiconductor lasers and a semiconductor optical amplifier. Thus, in a structure in which semiconductor lasers and a semiconductor optical amplifier use the same active layer as in the integrated semiconductor laser device described in Patent Literature 1 that has been known, characteristics of a narrow linewidth and high intensity of output laser light are tradeoffs, and both of them cannot be fulfilled at the same time.

Even when the semiconductor lasers and the semiconductor optical amplifier are configured to have different active layer configurations, there is a limit to increasing the optical power of the semiconductor optical amplifier since design guidelines on a configuration in which the thickness of the active layer of the semiconductor optical amplifier is smaller than the thickness of the active layer of the semiconductor lasers, as in the integrated semiconductor laser device according to Patent Literature 2, are to prevent gain saturation of the semiconductor optical amplifier. Further, no consideration is given to the spectral linewidth in the integrated semiconductor laser device according to Patent Literature 2, which is inappropriate to obtain a narrow linewidth.

Under the above consideration, in the integrated semiconductor laser device according to the first embodiment contrived by the present inventors, the active layers of the semiconductor lasers and the semiconductor optical amplifier are optimized individually, and the factor of optical confinement to the active layer of the semiconductor optical amplifier is set greater than the factor of optical confinement to the active layer of the semiconductor lasers. As a result, the integrated semiconductor laser device according to the first embodiment makes two characteristics, a narrow spectral linewidth and high intensity of output laser light, excellent at the same time.

It is preferable to set a wavelength corresponding to the bandgap energy of the active layer of the semiconductor optical amplifier slightly longer than a wavelength corresponding to the bandgap energy of the active layer of the semiconductor lasers. For example, in an integrated semiconductor laser device used at wavelengths of the 1550 nm band, it is preferable that, of the wavelengths corresponding to the bandgap energy of the active layer of the semiconductor lasers and the active layer of the semiconductor optical amplifier, the wavelength of the semiconductor optical amplifier is 5 nm to 20 nm longer. This can provide the semiconductor optical amplifier of a great gain.

The integrated semiconductor laser device according to the first embodiment of the present invention also has an effect of being able to increase the ratio between the intensity of laser light and the intensity of amplified spontaneous emission (ASE) light contained in output light.

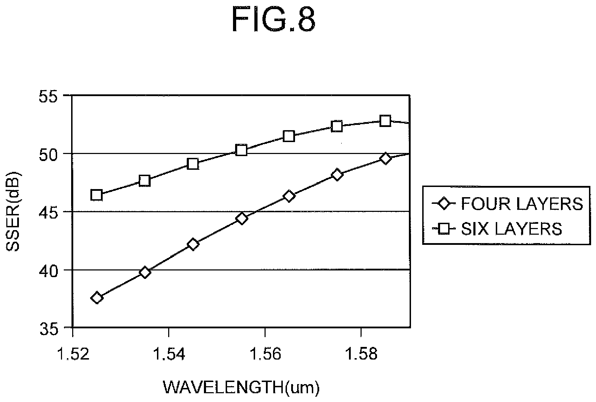

FIG. 8 is a graph showing the results of calculating the ratio between the intensity of laser light and the ASE optical intensity contained in output light of the semiconductor lasers. In FIG. 8, the horizontal axis is the emission wavelength of the semiconductor lasers, and the vertical axis is the signal to spontaneous emission ratio (SSER). The SSER is the ratio between the maximum optical intensity of laser light (per nm of the wavelength width) and the ASE optical intensity (per nm of the wavelength width) at a wavelength at which the optical intensity is maximum. As illustrated in FIG. 8, by reducing the number of quantum wells of the semiconductor lasers, there is an effect of increasing the ratio between the intensity of laser light and the ASE optical intensity. In integrated semiconductor laser devices, the ratio between laser optical intensity and ASE optical intensity is obtained as a value of the ratio between the laser optical intensity and the ASE optical intensity of a semiconductor laser as a single item on which the characteristics of a semiconductor optical amplifier are superimposed. The integrated semiconductor laser device according to the first embodiment of the present invention can improve the ratio between laser optical intensity and ASE optical intensity without reducing the amplification factor of the semiconductor optical amplifier.

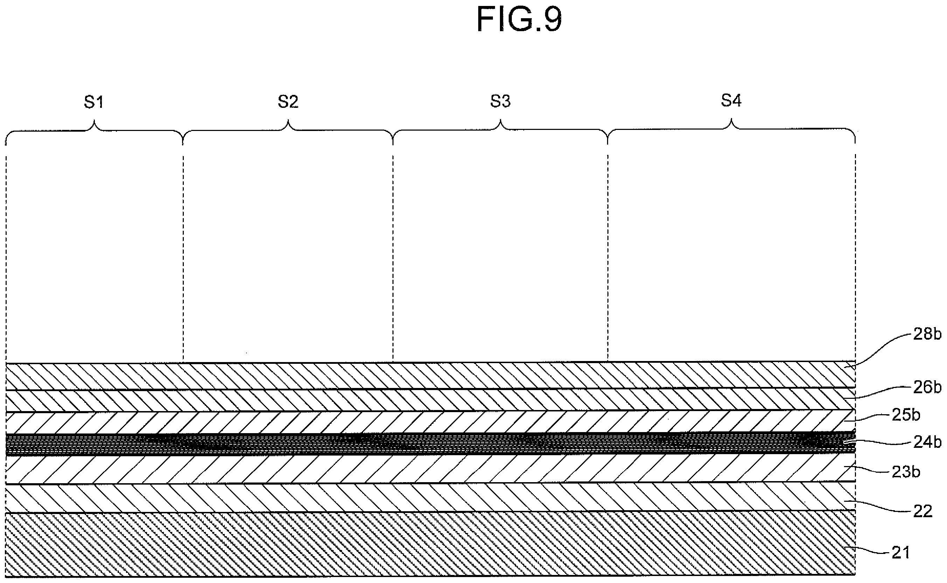

Next, with reference to FIGS. 9 to 15, a method of manufacturing the integrated semiconductor laser device 10 according to the first embodiment will be described. FIGS. 9 to 14 schematically illustrate a cross section along line D-D of the integrated semiconductor laser device 10 illustrated in FIG. 1 in manufacturing process steps.

First, as illustrated in FIG. 9, the n-type InP buffer layer 22, the lower InGaAsP-SCH layer 23b, the active layer 24b, the upper InGaAsP-SCH layer 25b, the InP spacer layer 26b, and the p-type InP cladding layer 28b are successively deposited on the n-type InP substrate 21, using a metalorganic chemical vapor deposition (MOCVD) method.

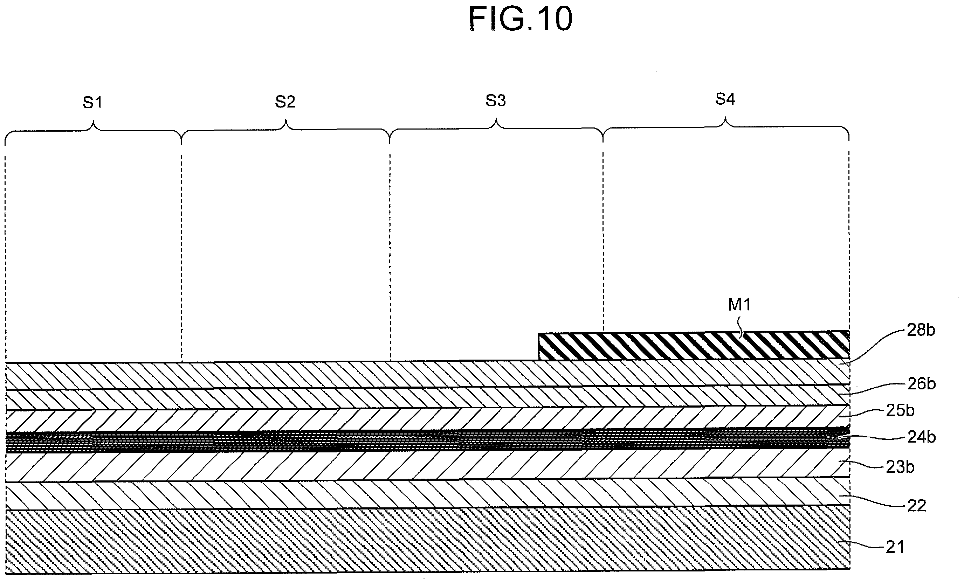

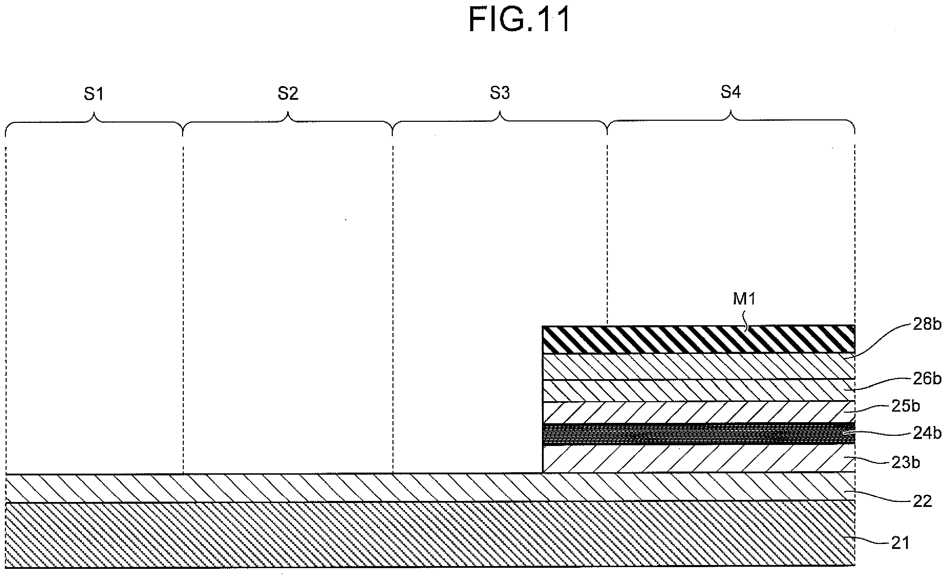

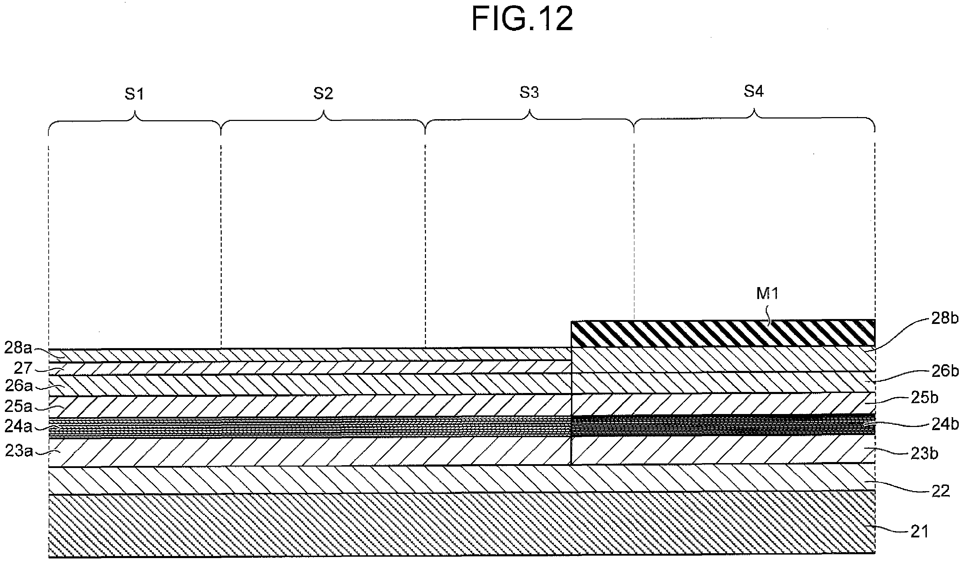

Next, after depositing an SiN film on the entire surface, it is patterned to be a pattern slightly wider than the region S4 to be the semiconductor optical amplifier 14, to form a mask M1 covering to a portion of the region S3 as illustrated in FIG. 10. Then, as illustrated in FIG. 11, etching is performed with the mask M1 of the SiN film as a mask for removal down to the lower InGaAsP-SCH layer 23b to expose the n-type InP buffer layer 22. Subsequently, as illustrated in FIG. 12, using the mask M1 as it is as a mask for selective growth, the lower InGaAsP-SCH layer 23a, the active layer 24a, the upper InGaAsP-SCH layer 25a, the InP spacer layer 26a, the InGaAsP grating layer 27, and the p-type InP cladding layer 28a are stacked by an MOCVD method.

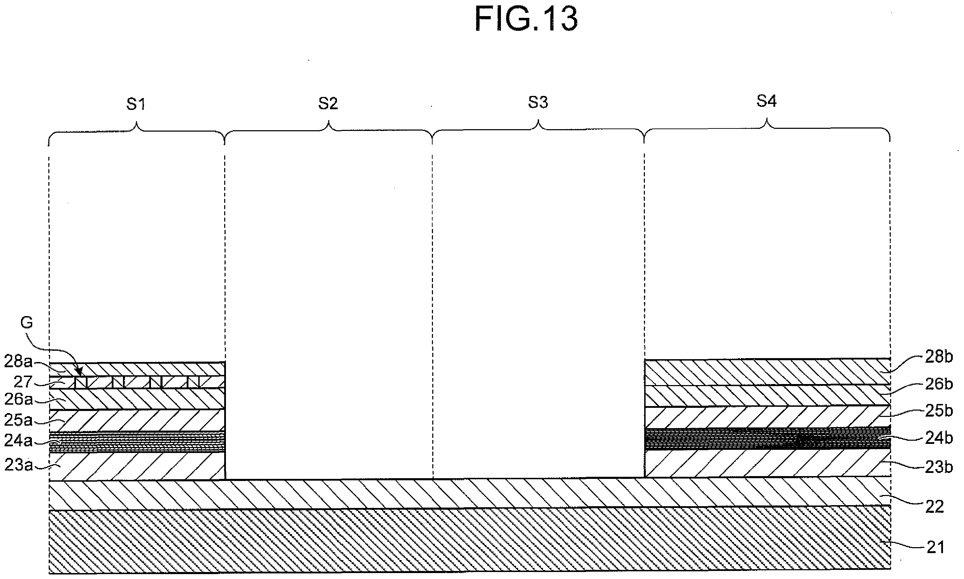

Next, after removing the mask M1, an SiN film is newly deposited on the entire surface, and is subjected to patterning to be patterns of diffraction gratings different from each other in periods in the respective positions to form the DFB laser stripes 11-1 to 11-n in the region S1. Then, etching is performed with the SiN film as a mask to form grooves G to be the diffraction gratins in the InGaAsP grating layer 27 (see the region S1 in FIG. 13). Next, after removing the mask of the SiN film, a p-type InP cladding layer is deposited again on the entire surface.

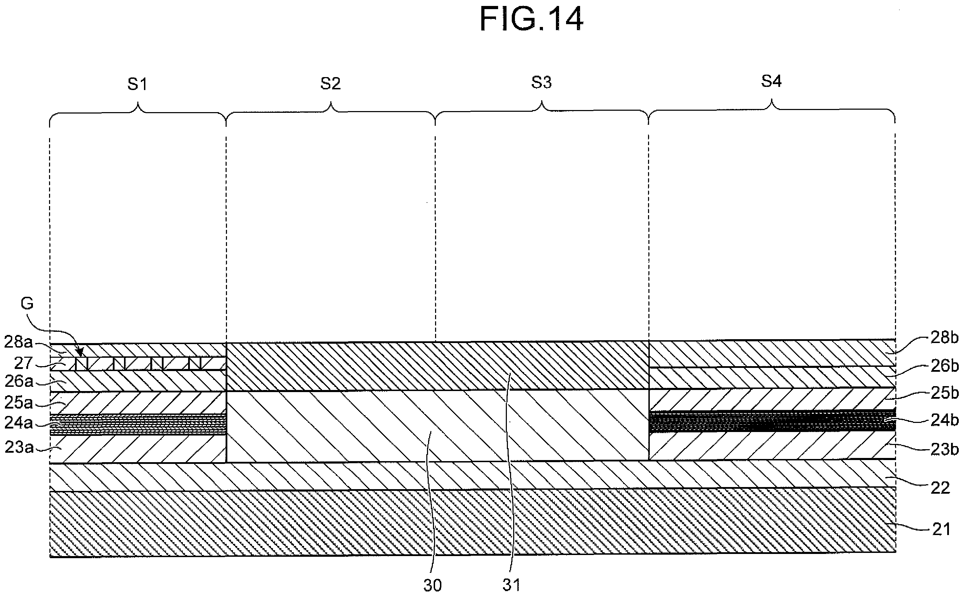

Next, after depositing an SiN film on the entire surface, it is subjected to patterning to be patterns of lengths corresponding to those of the region S1 to be the DFB laser stripes 11-1 to 11-n and the region S4 to be the semiconductor optical amplifier 14 and of slightly larger widths. At this time, for the region S4 to be the semiconductor optical amplifier 14, it is desirable to provide a pattern of a slightly smaller width than in the first patterning. Then, as illustrated in FIG. 13, etching is performed with the SiN film as a mask for removal down to the lower InGaAsP-SCH layers 23a and 23b, including the active layers 24a and 24b of two types to expose the n-type InP buffer layer 22. Subsequently, with the mask of the SiN film as it is as a mask for selective growth, the InGaAsP core layer 30 and the i-type InP layer 31 are stacked in the region S2 and the region S3 by a MOCVD method as illustrated in FIG. 14.

Next, after removing the mask of the SiN film, an SiN film is newly deposited and is subjected to patterning to be patterns corresponding to the DFB laser stripes 11-1 to 11-n, the optical waveguides 12-1 to 12-n, the MMI optical coupler 13, and the semiconductor optical amplifier 14 illustrated in FIG. 1. Then, etching is performed with the SiN film as a mask to form mesa structures corresponding to the DFB laser stripes 11-1 to 11-n, the optical waveguides 12-1 to 12-n, the MMI optical coupler 13, and the semiconductor optical amplifier 14 and to expose the n-type InP buffer layer 22 in the other region.

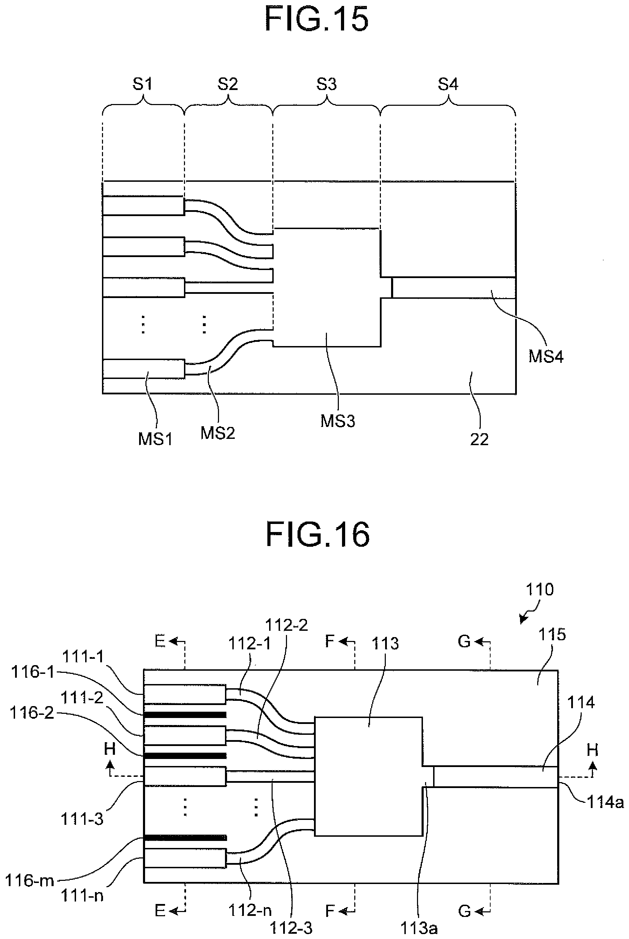

FIG. 15 is a schematic plan view explaining a state after performing this step. In the regions S1 to S4, mesa structures MS1 to MS4 having shapes corresponding to the DFB laser stripes 11-1 to 11-n, the optical waveguides 12-1 to 12-n, the MMI optical coupler 13, and the semiconductor optical amplifier 14, respectively, are formed.

Next, with the mask of the SiN film used in the previous step as a mask for selective growth, the p-type InP current blocking layer 32 and the n-type current blocking layer 33 are deposited successively on the exposed n-type InP buffer layer 22, using an MOCVD method. This forms the embedding portion 15. Next, after removing the mask of the SiN film, the p-type InP cladding layer 34 and the InGaAs contact layer 35 are deposited successively on the entire surface of the regions S1 to S4, using an MOCVD method.

Next, after depositing an SiN film on the entire surface, the SiN film is subjected to patterning to be a pattern corresponding to the trenches 16-1 to 16-m. Then, etching is performed with the SiN film as a mask to form the trenches 16-1 to 16-m.

The trenches 16-1 to 16-m are formed to a depth reaching the n-type InP buffer layer 22, for example, but only need to be formed to a depth at which electrical separation can be provided between the DFB laser stripes 11-1 to 11-n.

Next, after removing the mask of the SiN film, an SiN film is deposited again on the entire surface to form the SiN protective film 38 forming openings to the DFB laser stripes 11-1 to 11-n and the semiconductor optical amplifier 14. Further, after depositing a two-layer conductive film made of AuZn/Au on the entire surface, it is patterned to shapes corresponding to those of the DFB laser stripes 11-1 to 11-n and the semiconductor optical amplifier 14, thereby forming the p-side electrodes 39. On the other hand, on the rear surface of the n-type InP substrate 21, the n-side electrode 40 of a two-layer structure made of AuGeNi/Au is formed after adjusting the thickness of the n-type InP substrate 21 by grinding. By the above manufacturing process, the semiconductor optical amplifier 14, the DFB laser stripes 11-1 to 11-n, the optical waveguides 12-1 to 12-n, and the MMI optical coupler 13 are formed.

Finally, the n-type InP substrate 21 is cleaved in bar shapes in which a plurality of integrated semiconductor laser devices 10 is aligned. After coating both end facets at which the DFB laser stripes 11-1 to 11-n and the semiconductor optical amplifier 14 are formed with antireflective films, it is separated by the integrated semiconductor laser devices 10, thereby completing the integrated semiconductor laser devices 10.

As above, the integrated semiconductor laser device 10 according to the first embodiment is produced, and an integrated semiconductor laser device whose output laser light has a narrow spectral linewidth and high intensity is provided.

### (Example 1)

As a semiconductor laser module according to Example 1 of the present invention, a semiconductor laser module using an integrated semiconductor laser device having the configuration of the integrated semiconductor laser device 10 according to the first embodiment was produced.

The DFB laser stripes 11-1 to 11-n in Example 1 each have a stripe-shaped embedded structure of a width of 2.0 µm and a length of 1200 µm. The semiconductor optical amplifier of the integrated semiconductor laser device has a width of 2.0 µm and a cavity length of 1500 µm. n is 16.

The active layer 24a of the DFB laser stripes 11-1 to 11-n has a multiple quantum well active layer made of InGaAsP, in which the thickness of a quantum well layer is 6 nm and the number of quantum wells is four. The total thickness of the lower InGaAsP-SCH layer 23a, the active layer 24a, and the upper InGaAsP-SCH layer 25a is 145 nm. At this time, the sum of the factors of optical confinement to the quantum wells is 3.0%.

The active layer 24b of the semiconductor optical amplifier 14 has a multiple quantum well active layer made of InGaAsP, in which the thickness of a quantum well layer is 6 nm, and the number of quantum wells is six.

The total thickness of the lower InGaAsP-SCH layer 23b, the active layer 24b, and the upper InGaAsP-SCH layer 25b is 175 nm. At this time, the sum of the factors of optical confinement to the quantum wells is 5.4%.

In the semiconductor laser module according to Example 1, the temperature of the integrated semiconductor laser device was 55°C, and the driving current of the DFB laser stripes was set at 200 mA, and the driving current of the semiconductor optical amplifier was set at 300 mA. As a result, the spectral linewidth of output laser light of the semiconductor laser module was less than 300 kHz, and the optical intensity of output laser light of the semiconductor laser module was 40 mW.

The semiconductor laser module according to Example 1 was able to reduce the spectrum linewidth of output laser light by reducing the factor of optical confinement to the active layer of the DFB laser stripes. The semiconductor laser module according to Example 1 was able to increase the optical intensity of output laser light since the factor of optical confinement to the active layer of the semiconductor optical amplifier was increased.

Actual measurement of the SSER of output light of the semiconductor laser module according to Example 1 showed that it was 40 dB or more in a range of all wavelengths used. Thus, the semiconductor laser module according to Example 1 increased the ratio between the intensity of output laser light of the integrated semiconductor laser device and the optical intensity of ASE light, producing less noise.

### (Second Embodiment)

Next, an integrated semiconductor laser device according to a second embodiment of the present invention will be described. FIG. 16 is a schematic plan view of the integrated semiconductor laser device according to the second embodiment of the present invention. As illustrated in FIG. 16, an integrated semiconductor laser device 110 according to the second embodiment of the present invention is configured as an integrated semiconductor laser device. The integrated semiconductor laser device 110 has a structure in which a plurality of DR laser stripes 111-1 to 111-n (n is an integer of two or more), semiconductor lasers to output laser light, a plurality of optical waveguides 112-1 to 112-n, an MMI optical coupler 113, and a semiconductor optical amplifier 114 to amplify output laser light of the DR laser stripes 111-1 to 111-n are integrated on a single semiconductor substrate, and an embedding portion 115 is formed around them. Trenches 116-1 to 116-m (m = n - 1) are provided between the DR laser stripes 111-1 to 111-n to electrically separate the DR laser stripes. Although a form having the plurality of DR laser stripes 111 is herein described, the number of the DR laser stripes 111 may be one, in which case trenches are unnecessary.

The DR laser stripes 111-1 to 111-n are each an edge emitting laser having a stripe-shaped embedded structure of a width of 1.3 to 2.5 µm, and are formed with a pitch of 25 µm in a lateral direction at one end opposite to an output end 114a on the optical power side of the integrated semiconductor laser device 110. The DR laser stripes 111-1 to 111-n have a distributed feedback laser section to which current injection is performed, and a distributed Bragg reflection section to which current injection is not performed as described below, which sections have lengths of 1200 µm and 300 µm, respectively. The DR laser stripes 111-1 to 111-n are configured so that their wavelengths of output laser light are different in a range of the 1550 nm band (e.g. 1530 nm to 1570 nm) by making the pitches of diffraction gratings provided to the DR laser stripes different from each other. The laser emission wavelengths of the DR laser stripes 111-1 to 111-n can be adjusted by changing the set temperature of the integrated semiconductor laser device 110. That is, the integrated semiconductor laser device 110 provides a wide wavelength-variable range by switching among the DR laser stripes to be driven and temperature control.

The optical waveguides 112-1 to 112-n have the same configuration as the optical waveguides 12-1 to 12-n in the first embodiment, but are not particularly limited. The MMI optical coupler 113 has the same configuration as the MMI optical coupler 13 in the first embodiment, but is not particularly limited. The semiconductor optical amplifier 114 connected to an output port 113a of the MMI optical coupler 113 has the same configuration as the semiconductor optical amplifier 14 in the first embodiment except for the design of a lower SCH layer, an active layer, and an upper SCH layer described below, but is not particularly limited.

A cross-sectional view of a principal part along line E-E in FIG. 16, a cross section of the DR laser stripes in the integrated semiconductor laser device 110, a cross-sectional view of a principal part along line F-F in FIG. 16, a cross section of the MMI optical coupler 113, and a cross-sectional view of a principal part along line G-G in FIG. 16, a cross section of the semiconductor optical amplifier 114, are the same as those in FIGS. 2, 3, and 4, respectively.

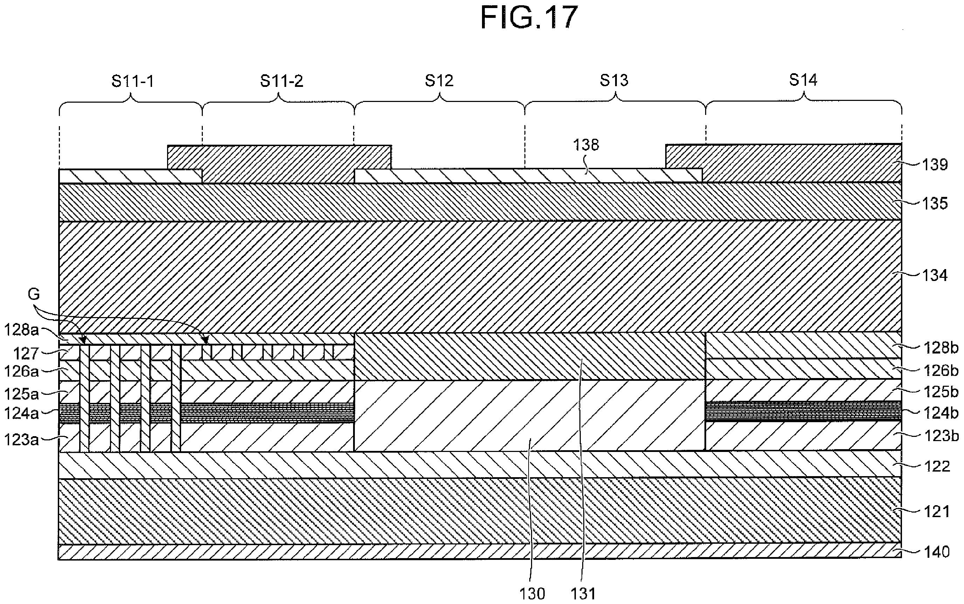

FIG. 17 is a cross-sectional view of a principal part along line H-H of the integrated semiconductor laser device illustrated in FIG. 16. In FIG. 17, a region S11-1 represents the distributed Bragg reflection section of the DR laser stripe, a region S11-2 the distributed feedback laser section of the DR laser stripe, a region S12 the optical waveguide, a region S13 the MMI optical coupler 113, and a region S14 the semiconductor optical amplifier 114. As illustrated in FIG. 17, the DR laser stripe, the optical waveguide, the MMI optical coupler 113, and the semiconductor optical amplifier 114 are formed on the same n-type InP substrate 121 and n-type InP buffer layer 122. On the rear surface of the n-type InP substrate 121, an n-side electrode 140 is formed.

The distributed feedback laser section and the distributed Bragg reflection section have a lower InGaAsP-SCH layer 123a, an active layer 124a, a first active layer containing a multiple quantum well layer, and an upper InGaAsP-SCH layer 125a of the same design formed on the n-type InP buffer layer 122. The distributed feedback laser section and the distributed Bragg reflection section further have a structure in which an InP spacer layer 126a, an InGaAsP grating layer 127 formed with a grating in which grooves G are disposed at regular intervals, and a p-type InP cladding layer 128a are stacked successively on the upper InGaAsP-SCH layer 125a. In the distributed feedback laser section, the lower InGaAsP-SCH layer 123a, the active layer 124a, and the upper InGaAsP-SCH layer 125a are continuous in an optical cavity length direction, and the InGaAsP grating layer 127 is disposed in the vicinity of the active layer 124a along the active layer 124a. In the distributed Bragg reflection section, the lower InGaAsP-SCH layer 123a, the active layer 124a, and the upper InGaAsP-SCH layer 125a are disposed discretely and periodically to form a diffraction grating, the period of which is the same as the period of the InGaAsP grating layer 127.

A mesa structure is formed from the p-type InP cladding layer 128a to a depth reaching halfway through the n-type InP buffer layer 122 to constitute the DR laser stripe. Both lateral sides of the mesa structure are embedded by a stacked structure of a p-type InP current blocking layer and an n-type current blocking layer constituting the embedding portion 115.

The DR laser stripe further includes a p-type InP cladding layer 134 and an InGaAs contact layer 135 formed successively on the p-type InP cladding layer 128a and the n-type current blocking layer. The active layer 124a, and the lower InGaAsP-SCH layer 123a, the upper InGaAsP-SCH layer 125a, the n-type InP buffer layer 122, and the p-type InP cladding layers 128a, 134 sandwiching the active layer 124a from above and below constitute a waveguide structure. The trenches 116-1 to 116-m are formed from the InGaAs contact layer 135 to a depth reaching halfway through the n-type InP buffer layer 122. An SiN protective film 138 is formed to cover the surface of the InGaAs contact layer 135 and the inner surfaces of the trenches 116-1 to 116-m. An opening not covered by the SiN protective film 138 is formed on the top surface of the InGaAs contact layer 135 in a position corresponding to the distributed feedback laser section of the DR laser stripe. A p-side electrode 139 is formed to contact the InGaAs contact layer 135 at the opening. At this time, no opening is formed in the SiN protective film 138 in a position corresponding to the distributed Bragg reflection section. Therefore, the p-side electrode 139 does not contact the InGaAs contact layer 135 in the position corresponding to the distributed Bragg reflection section of the DR laser stripe (See FIG. 17).

The active layer 124a has the same composition, the same quantum well layer thickness, the same number of quantum wells, and the same total thickness of the lower InGaAsP-SCH layer 123a, the active layer 124a, and the upper InGaAsP-SCH layer 125a as the active layer 24a in the first embodiment. The sum of the factors of optical confinement to the quantum wells is also the same as that of the active layer 24a, 3.0%.

The MMI optical coupler 113 has the same configuration as the MMI optical coupler 13 in the first embodiment. An InGaAsP core layer 130 and an i-type InP layer 131 correspond to the InGaAsP core layer 30 and the i-type InP layer 31, respectively. Thus, the composition of InGaAsP constituting the InGaAsP core layer 130 is set so that its bandgap wavelength is shorter than the laser emission wavelengths of the DR laser stripes 111-1 to 111-n.

An active layer 124b of the semiconductor optical amplifier 114 is made of AlGaInAs, and has the same quantum well layer thickness and the same number of quantum wells as the active layer 24b in the first embodiment. As SCH layers in which the composition is changed stepwise, a lower AlGaInAs-SCH layer 123b and an upper AlGaInAs-SCH layer 125b are provided. The total thickness of the lower AlGaInAs-SCH layer 123b, the active layer 124b, and the upper AlGaInAs-SCH layer 125b is 150 nm. At this time, the sum of the factors of optical confinement to the quantum wells is calculated as 5.8%.

Suitable ranges of parameters of the components in the second embodiment are the same as the ranges illustrated as suitable ranges of parameters on the corresponding components in the first embodiment.

The integrated semiconductor laser device 110 operates the same as the integrated semiconductor laser device 10 according to the first embodiment.

Here, as described above, the active layer 124a of the DR laser stripes 111-1 to 111-n and the active layer 124b of the semiconductor optical amplifier 114 are different in their configurations. For example, the number of quantum wells in the active layer 124a of the DR laser stripes 111-1 to 111-n is four, and the number of quantum wells in the active layer 124b of the semiconductor optical amplifier 114 is six. Due to the difference in configuration, the factor of optical confinement to the active layer 124b of the semiconductor optical amplifier 114 (5.8%) is greater than the factor of optical confinement to the active layer 124a of the DR laser stripes 111-1 to 111-n (3.0%). Thus, the integrated semiconductor laser device 110, like the integrated semiconductor laser device 10 according to the first embodiment, provides output laser light of a narrow spectral linewidth and high intensity. In the second embodiment, the ratio between the factors of optical confinement to the quantum wells of the DR laser stripes 111-1 to 111-n and the semiconductor optical amplifier 114 is 1.9 times or more, greater than the ratio between the factors of optical confinement to the quantum wells of the DFB laser stripes 11-1 to 11-n and the semiconductor optical amplifier 14 in the first embodiment. When the DR lasers are used, the number of quantum wells in lasers suitable to obtain desired characteristics is smaller than that when the DFB lasers are used. Therefore, in the second embodiment, the difference in the suitable number of quantum wells between the lasers and the semiconductor optical amplifier is increased. Accordingly, the difference in the optical confinement factors is also increased, thus being able to provide an even greater effect of the embodiments of the present invention.

Next, an example of a method of manufacturing the integrated semiconductor laser device according to the second embodiment will be described. The method of manufacturing the integrated semiconductor laser device according to the second embodiment allows manufacture in the same manner as in the first embodiment except for a step of producing the DR laser stripes 111-1 to 111-n. Therefore, the step of producing the DR laser stripes 111-1 to 111-n will be mainly described, referring to FIGS. 9 to 15 explaining the method of manufacturing the integrated semiconductor laser device 10 according to the first embodiment as appropriate.

First, the n-type InP buffer layer 122, the lower AlGaInAs-SCH layer 123b, the active layer 124b, the upper layer 125b, the InP spacer layer 126b, and the p-type InP cladding layer 128b are successively deposited on the n-type InP substrate 121 (see also FIG. 9). The active layer 124b is an active layer included in the semiconductor optical amplifier 114.

Next, after depositing an SiN film on the entire surface, it is patterned to be a pattern slightly wider than the region S14 to be the semiconductor optical amplifier 114, to form a mask covering to a portion of the region S13 (see also FIG. 10). Then, etching is performed with the mask of the SiN film as a mask for removal down to the lower layer 123b to expose the n-type InP buffer layer 122 (see also FIG. 11). Subsequently, using the mask as it is as a mask for selective growth, the lower InGaAsP-SCH layer 123a, the active layer 124a, the upper InGaAsP-SCH layer 125a, the InP spacer layer 126a, the InGaAsP grating layer 127, and the p-type InP cladding layer 128a are stacked (see FIG. 12). The active layer 124a is an active layer included in the DR laser stripes 111-1 to 111-n.

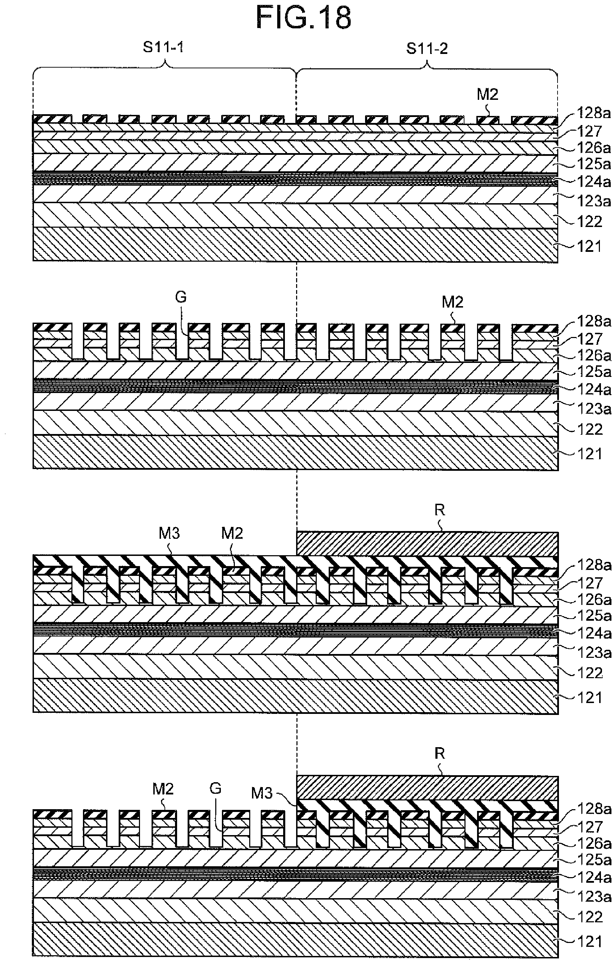

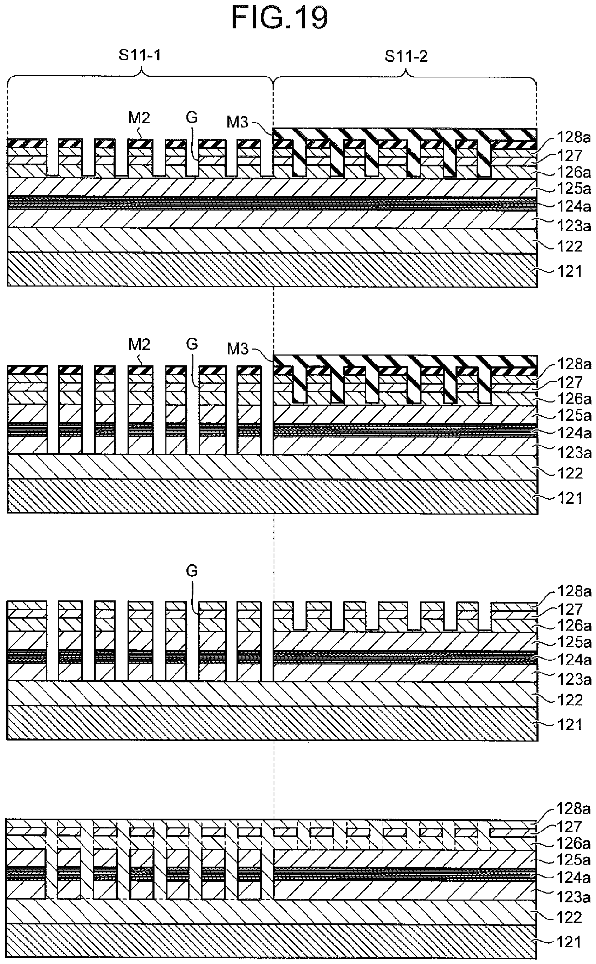

Next, the DR laser stripes 111-1 to 111-n having the distributed feedback laser section and the distributed Bragg reflection section are formed. FIGS. 18 and 19 are diagrams explaining the method of manufacturing the integrated semiconductor laser device illustrated in FIG. 16. First, after removing the mask (corresponding to the mask M1 in FIG. 12), as illustrated in the uppermost diagram in FIG. 18, an SiN film is newly deposited on the entire surface, and is subjected to patterning to be patterns of diffraction gratings different from each other in periods in the respective positions to form the DR laser stripes 111-1 to 111-n in the region S11-1 to be the distributed Bragg reflection section and the region S11-2 to be the distributed feedback laser section, to be a mask M2. Then, as illustrated in the second diagram from above in FIG. 18, etching is performed with the mask M2 as a mask by dry etching equipment using methane and hydrogen as etching gas, to form grooves G to be a diffraction grating in the InGaAsP grating layer 127.

Further, as illustrated in the third diagram from above in FIG. 18, a mask M3 is formed to fill the grooves G and cover the mask M2, and further a resist film R is formed on the mask M3 in the region S11-2 to be the distributed feedback laser section. Here, the mask M3 is of a material having an etching rate to a predetermined etchant different from the etching rate of the mask M2. The material of the mask M3 is, for example, SiO₂. Spin-on-glass (SOG) can be used. When the mask M3 is made of SiO₂, the mask M2 may be a film made of silicon or metal.

Next, as illustrated in the lowermost diagram in FIG. 18, the mask M3 in the region S11-1 to be the distributed Bragg reflection section is removed by a buffered hydrofluoric acid solution (BHF) to expose the grooves G. At this time, since the etching rate of the mask M3 to BHF is greater than the etching rate of the mask M2 to BHF, the mask M3 is selectively etched, and the mask M2 is left.

Next, as illustrated in the uppermost diagram in FIG. 19, the resist film R is removed. Further, as illustrated in the second diagram from above in FIG. 19, etching is performed by dry etching equipment using methane and hydrogen as etching gas to further etch the grooves G deeply to a depth reaching the bottom surface of the lower InGaAsP-SCH layer 123a. As a result, in the region S11-1 to be the distributed Bragg reflection section, the lower InGaAsP-SCH layer 123a, the active layer 124a, and the upper InGaAsP-SCH layer 125a are separated by the grooves G, forming diffraction grating structures disposed periodically. On the other hand, in the region S11-2 to be the distributed feedback laser section, the lower InGaAsP-SCH layer 123a, the active layer 124a, and the upper InGaAsP-SCH layer 125a remain continuous over an optical cavity length direction. That is, this step is a step performed by forming the mask M3 on the outermost surface in the region S11-2 to be the distributed feedback laser section to protect the lower InGaAsP-SCH layer 123a, the active layer 124a, and the upper InGaAsP-SCH layer 125a in the region S11-2 to be the distributed feedback laser section from etching in this step.

In the distributed Bragg reflection section, the InGaAsP grating layer 127 does not necessarily need to exist. However, the InGaAsP grating layer 127 also contributes to coupling factor κ in the distributed Bragg reflection section, and thus does not need to be removed particularly in the manufacturing process.

Thereafter, as illustrated in the third diagram from above in FIG. 19, the masks M2, M3 are removed. As illustrated in the lowermost diagram in FIG. 19, the p-type InP cladding layer 128a is deposited again on the entire surface.

By the above steps, the DR structure of the DR laser stripes 111-1 to 111-n is formed. Thereafter, a step corresponding to the step described with reference to FIG. 13 in the method of manufacturing the integrated semiconductor laser device 10, and steps after that are performed as appropriate to complete the integrated semiconductor laser device 110.

In the method of manufacturing the integrated semiconductor laser device according to the second embodiment, processing of the distributed Bragg reflection section of the DR laser stripes is performed by etching using methane and hydrogen as etching gas. In dry etching using methane and hydrogen as etching gas, InP and InGaAsP are etched well, but etching hardly proceeds on AlGaInAs. On the other hand, in dry etching using chorine-based gas as etching gas, etching on AlGaInAs proceeds well, but a semiconductor is greatly damaged, and thus it is not suitable for fine processing on an active layer. Therefore, in this type of DR laser stripes whose active layer is etched, the active layer is preferably InGaAsP instead of AlGaInAs in terms of processing. In the integrated semiconductor laser device according to the second embodiment, the material constituting the active layer of the semiconductor optical amplifier is AlGaInAs, and the material constituting the active layer of the DR laser stripes is InGaAsP. Thus, there is an advantage that processing is easily performed in the DR laser stripes while good gain characteristics of AlGaInAs is utilized in the semiconductor optical amplifier.

As above, the integrated semiconductor laser device 110 according to the second embodiment is produced, and an integrated semiconductor laser device whose output laser light has a narrow spectral line width and high intensity is provided.

### (Example 2)

As a semiconductor laser module according to Example 2 of the present invention, a semiconductor laser module using an integrated semiconductor laser device having the configuration of the integrated semiconductor laser device 110 according to the second embodiment was produced.

The DR laser stripes 111-1 to 111-n in Example 2 each have a stripe-shaped embedded structure of a width of 2.0 µm and a length of 1200 µm. The semiconductor optical amplifier of the integrated semiconductor laser device has a width of 2.0 µm. The distributed feedback laser section and the distributed Bragg reflection section have lengths of 1200 µm and 300 µm, respectively. n is 16.

The active layer 124a of the DR laser stripes 111-1 to 111-n has a multiple quantum well active layer made of InGaAsP, in which the thickness of a quantum well layer is 6 nm and the number of quantum wells is four. The total thickness of the lower InGaAsP-SCH layer 123a, the active layer 124a, and the upper InGaAsP-SCH layer 125a is 145 nm. At this time, the sum of the factors of optical confinement to the quantum wells is 3.0%.

The active layer 124b of the semiconductor optical amplifier 114 has a multiple quantum well active layer made of AlGaInAs, in which the thickness of a quantum well layer is 6 nm, and the number of quantum wells is six.

The total thickness of the lower AlGaInAs-SCH layer 123b, the active layer 124b, and the upper layer 125b is 150 nm. At this time, the sum of the factors of optical confinement to the quantum wells is 5.8%.

When the integrated semiconductor laser device was 30°C, in the semiconductor laser module in Example 2, the driving current of the DR laser stripes was set at 200 mA, and the driving current of the semiconductor optical amplifier was set at 250 mA. As a result, the spectral linewidth of output laser light of the semiconductor laser module was 150 kHz, and the optical intensity of output laser light of the semiconductor laser module was 40 mW. Further, when the integrated semiconductor laser device was 70°C, in the semiconductor laser module in Example 2, the driving current of the DR laser stripes was set at 200 mA, and the driving current of the semiconductor optical amplifier was set at 400 mA. The spectral linewidth of output laser light of the semiconductor laser module was 150 kHz, and the optical intensity of output laser light of the semiconductor laser module was 40 mW.

The semiconductor laser module according to Example 2 was able to narrow the spectrum linewidth of output laser light by reducing the factor of optical confinement to the active layer of the DR laser stripes to provide DR laser stripes further advantageous in a narrow linewidth. The semiconductor laser module according to Example 2 was also able to increase the optical intensity of output laser light since the factor of optical confinement to the active layer of the semiconductor optical amplifier was increased, and further, an AlGaInAs active layer having excellent high gain characteristics was used in the semiconductor optical amplifier.

Further, the semiconductor laser module according to Example 2 suffers less characteristic degradation even at high temperatures. Thus, the semiconductor laser module according to Example 2 can be used with the integrated semiconductor laser device increased in temperature, and thus allowed a reduction in the power consumption of a temperature control component of the semiconductor laser module.

As described above, according to the present embodiment, an integrated semiconductor laser device whose output laser light has a narrow spectral linewidth and high intensity can be provided.

In the above embodiments, the integrated semiconductor laser device including the DFB laser stripes or the DR laser stripes, a plurality of semiconductor lasers, and the semiconductor optical amplifier, and further includes the optical waveguides and the MMI optical coupler has been described.

In the above embodiments, a configuration in which the number of quantum wells in an active layer of a semiconductor optical amplifier is made larger than the number of quantum wells in an active layer of semiconductor lasers is adopted to make the factor of optical confinement to the active layer of the semiconductor optical amplifier greater than the factor of optical confinement to the active layer of the semiconductor lasers.

### Industrial Applicability

As above, an integrated semiconductor laser device and a semiconductor laser module according to the present invention are suitably used mainly for optical communications.

### Reference Signs List

10, 110 INTEGRATED SEMICONDUCTOR LASER DEVICE
11-1 to 11-n DFB LASER STRIPE
111-1 to 111-n DR LASER STRIPE
12-1 to 12-n, 112-1 to 112-n OPTICAL WAVEGUIDE
13, 113 MMI OPTICAL COUPLER
13a, 113a OUTPUT PORT
14, 114 SEMICONDUCTOR OPTICAL AMPLIFIER
14a, 114a OUTPUT END
15, 115 EMBEDDING PORTION
16-1 to 16-m, 116-1 to 116-m TRENCH
21, 121 n-TYPE InP SUBSTRATE
22, 122 n-TYPE InP BUFFER LAYER
23a, 23b, 123a LOWER InGaAsP-SCH LAYER
123b LOWER A1GaInAs-SCH LAYER
24a, 24b, 124a, 124b ACTIVE LAYER
25a, 25b, 125a UPPER InGaAsP-SCH LAYER
125b UPPER LAYER
26a, 26b, 126a, 126b InP SPACER LAYER
27, 127 InGaAsP GRATING LAYER
28a, 28b, 128a, 128b p-TYPE InP CLADDING LAYER
30, 130 InGaAsP CORE LAYER
31, 131 i-TYPE InP LAYER
32 p-TYPEe InP CURRENT BLOCKING LAYER
33 n-TYPE CURRENT BLOCKING LAYER
34, 134 p-TYPE InP CLADDING LAYER
35, 135 InGaAs CONTACT LAYER
38, 138 SiN PROTECTIVE FILM
39, 139 p-SIDE ELECTRODE
40, 140 n-SIDE ELECTRODE
G GROOVE
M1 to M3 MASK
MS1 to MS4 MESA STRUCTURE
R RESIST FILM

## Claims

1. An integrated semiconductor laser device (10) comprising:
a semiconductor laser (11);
a semiconductor optical amplifier (14) configured to amplify output laser light of the semiconductor laser (11), and
an optical waveguide (12) optically connected to the semiconductor laser and configured to guide the output laser light of the semiconductor laser,
wherein
the semiconductor laser (11) and the semiconductor optical amplifier (14) are horizontally integrated on a same surface of a semiconductor substrate (21),
the semiconductor laser (11) includes a first active layer,
the semiconductor optical amplifier (14) includes a second active layer,
the first active layer and the second active layer each include a multiple quantum well structure including quantum wells, , and
the second active layer includes a larger number of quantum wells than the first active layer.

2. The integrated semiconductor laser device (10) according to claim 1, wherein the number of quantum wells in the second active layer is five or more.

3. The integrated semiconductor laser device (10) according to any one of claims 1 to 2, wherein the number of quantum wells in the first active layer is five or less.

4. The integrated semiconductor laser device (10) according to any one of claims 1 to 3, wherein the second active layer has a longer wavelength corresponding to bandgap energy than the first active layer.

5. The integrated semiconductor laser device (10) according to any one of claims 1 to 4, comprising an optical loss unit disposed between the semiconductor laser (11) and the semiconductor optical amplifier (14), and configured to cause a loss to optical intensity of output laser light of the semiconductor laser (11) to be input to the semiconductor optical amplifier (14).

6. The integrated semiconductor laser device (10) according to any one of claims 1 to 5, comprising:
a plurality of the semiconductor lasers (10) that are configured to be different from each other in wavelengths of output laser light; and
the optical coupler configured to couple the output laser light of the plurality of semiconductor lasers (11).

7. The integrated semiconductor laser device (10) according to any one of claims 1 to 6, wherein the semiconductor laser (11) has a length of 1000 µm or more in an optical cavity

8. The integrated semiconductor laser device (10) according to any one of claims 1 to 7, wherein
the semiconductor laser (11) and the semiconductor optical amplifier (14) are integrated on the substrate made of InP, and
the first active layer and the second active layer contain an InGaAsP-based material.

9. The integrated semiconductor laser device (10) according to any one of claims 1 to 7, wherein
the semiconductor laser (10) and the semiconductor optical amplifier (14) are integrated on the substrate made of InP,
the first active layer contains an InGaAsP-based material, and
the second active layer contains an AlGaInAs-based material.

10. The integrated semiconductor laser device (10) according to any one of claims 1 to 9, wherein
the semiconductor laser (11) has a distributed feedback laser section and a distributed Bragg reflection section,
in the distributed feedback laser section, the first active layer is continuous over an optical cavity length direction, and a diffraction grating layer is disposed in the vicinity of the first active layer along the first active layer, and
in the distributed Bragg reflection section, the first active layer is disposed discretely and periodically to form a diffraction grating.

11. A semiconductor laser module comprising the integrated semiconductor laser device (10) according to any one of claims 1 to 10.

## Patentansprüche

1. Integrierte Halbleiterlasereinrichtung (10), die aufweist:
einen Halbleiterlaser (11);
einen optischen Halbleiterverstärker (14), der konfiguriert ist, um ein Ausgangslaserlicht von dem Halbleiterlaser (11) zu verstärken, und
einen optischen Wellenleiter (12), der optisch an den Halbleiterlaser angeschlossen ist und konfiguriert ist, um das Laserausgangslicht von dem Halbleiterlaser zu führen,
wobei
der Halbleiterlaser (11) und der optische Halbleiterverstärker (14) horizontal auf einer gleichen Oberfläche von einem Halbleitersubstrakt (20) integriert sind,
der Halbleiterlaser (11) eine erste aktive Schicht enthält,
der optische Halbleiterverstärker (14) eine zweite aktive Schicht enthält,
die erste aktive Schicht und die zweite aktive Schicht jeweils mehrere Quantentopfstrukturen enthalten, die Quantentöpfe enthalten, und
die zweite aktive Schicht enthält eine größere Anzahl von Quantentöpfen als die erste aktive Schicht.

2. Integrierte Halbleiterlasereinrichtung (10), gemäß Anspruch 1, wobei die Anzahl von Quantentöpfen in der zweiten aktiven Schicht fünf oder mehr beträgt.

3. Integrierte Halbleiterlasereinrichtung (10) gemäß irgendeinem der Ansprüche 1 bis 2, wobei die Anzahl von Quantentöpfen in der ersten aktiven Schicht fünf oder weniger beträgt.

4. Integrierte Halbleiterlasereinrichtung (10) gemäß irgendeinem der Ansprüche 1 bis 3, wobei die zweite aktive Schicht eine längere Wellenlänge entsprechend zu einer Bandlückenenergie als die erste aktive Schicht hat.

5. Integrierte Halbleiterlasereinrichtung (10) gemäß irgendeinem der Ansprüche 1 bis 4, die eine optische Verlusteinheit aufweist, die zwischen dem Halbleiterlaser (11) und dem optischen Halbleiterverstärker (14) angeordnet ist, und konfiguriert ist, um einen Verlust für die optischen Intensität von dem Laserausgangslicht von dem Halbleiterlaser (11) zu verursachen, das in dem Eingang des optischen Halbleiterverstärker (14) einzugeben ist.

6. Integrierte Halbleiterlasereinrichtung (10) gemäß irgendeinem der Ansprüche 1 bis 5, die aufweist:
mehrere von den Halbleiterlasern (10), die konfiguriert sind, um voneinander verschieden bezüglich der Wellenlänge des Laserausgangslichts zu sein; und
der optische Koppler ist konfiguriert, um das Laserausgangslicht von den mehreren Halbleiterlasern (11) zu koppeln.

7. Integrierte Halbleiterlasereinrichtung (10) gemäß irgendeinem der Ansprüche 1 bis 6, wobei der Halbleiterlaser (11) eine Länge von 1000 µm oder mehr in einer Längsrichtung einer optischen Kavität hat.

8. Integrierte Halbleiterlasereinrichtung (10) gemäß irgendeinem der Ansprüche 1 bis 7, wobei der Halbleiterlaser (11) und der optische Halbleiterverstärker (14) auf dem Substrat integriert sind, das aus InP gemacht ist, und
die erste aktive Schicht und die zweite aktive Schicht enthalten ein auf InGaAsPbasierendes Material.

9. Integrierte Halbleiterlasereinrichtung (10) gemäß irgendeinem der Ansprüche 1 bis 7, wobei
der Halbleiterlaser (10) und der optische Halbleiterverstärker (14) auf dem Substrat integriert sind, das aus InP gemacht ist,
die erste aktive Schicht enthält ein auf InGaAsP basierendes Material, und
die zweite aktive Schicht enthält ein auf AlGalnAs basierendes Material.

10. Integrierte Halbleiterlasereinrichtung (10) gemäß irgendeinem der Ansprüche 1 bis 9, wobei
der Halbleiterlaser (11) einen verteilten Feedback-Laserabschnitt (DFB-Laserabschnitt) und einen verteilten Bragg-Reflektionsabschnitt hat,
in dem DFB-Laserabschnitt ist die erste aktive Schicht über eine optische Kavitätslängenrichtung kontinuierlich, und eine Beugungsgitterschicht ist in der Nähe von der ersten aktiven Schicht entlang der ersten aktiven Schicht angeordnet, und
in dem verteilten Bragg-Reflektionsabschnitt ist die erste aktive Schicht direkt und periodisch angeordnet, um ein Beugungsgitter auszubilden.

11. Halbleiterlasermodul, das die integrierte Halbleiterlasereinrichtung (10) gemäß irgendeinem der Ansprüche 1 bis 10 aufweist.

## Revendications

1. Dispositif laser semi-conducteur intégré (10), comprenant :
un laser semi-conducteur (11) ;
un amplificateur optique semi-conducteur (14) configuré pour amplifier de la lumière laser de sortie du laser semi-conducteur (11), et
un guide d'ondes optique (12) optiquement connecté au laser semi-conducteur et configuré pour guider la lumière laser de sortie du laser semi-conducteur,
dans lequel
le laser semi-conducteur (11) et l'amplificateur optique semi-conducteur (14) sont horizontalement intégrés sur une même surface d'un substrat semi-conducteur (21),
le laser semi-conducteur (11) inclut une première couche active,
l'amplificateur optique semi-conducteur (14) inclut une seconde couche active,
la première couche active et la seconde couche active incluent chacune une structure à multiples puits quantiques incluant des puits quantiques, et
la seconde couche active inclut un nombre de puits quantiques plus grand que celui de la première couche active.

2. Dispositif laser semi-conducteur intégré (10) selon la revendication 1, dans lequel le nombre de puits quantiques dans la seconde couche active est de cinq ou plus.

3. Dispositif laser semi-conducteur intégré (10) selon l'une quelconque des revendications 1 et 2, dans lequel le nombre de puits quantiques dans la première couche active est de cinq ou moins.

4. Dispositif laser semi-conducteur intégré (10) selon l'une quelconque des revendications 1 à 3, dans lequel la seconde couche active a une longueur d'onde, correspondant à une énergie de bande interdite, plus longue que celle de la première couche active.

5. Dispositif laser semi-conducteur intégré (10) selon l'une quelconque des revendications 1 à 4, comprenant une unité à perte optique disposée entre le laser semi-conducteur (11) et l'amplificateur optique semi-conducteur (14), et configurée pour faire en sorte qu'une perte d'intensité optique de lumière laser de sortie du laser semi-conducteur (11) soit entrée dans l'amplificateur optique semi-conducteur (14).

6. Dispositif laser semi-conducteur intégré (10) selon l'une quelconque des revendications 1 à 5, comprenant :
une pluralité des lasers semi-conducteur (10) qui sont configurés pour être différents les uns des autres en ce qui concerne des longueurs d'onde de lumière laser de sortie ; et
le coupleur optique configuré pour coupler la lumière laser de sortie de la pluralité de lasers semi-conducteur (11).

7. Dispositif laser semi-conducteur intégré (10) selon l'une quelconque des revendications 1 à 6, dans lequel le laser semi-conducteur (11) a une longueur de 1000 µm ou plus dans une cavité optique.

8. Dispositif laser semi-conducteur intégré (10) selon l'une quelconque des revendications 1 à 7, dans lequel
le laser semi-conducteur (11) et l'amplificateur optique semi-conducteur (14) sont intégrés sur le substrat fait d'InP, et
la première couche active et la seconde couche active contiennent un matériau à base d'InGaAsP.

9. Dispositif laser semi-conducteur intégré (10) selon l'une quelconque des revendications 1 à 7, dans lequel
le laser semi-conducteur (10) et l'amplificateur optique semi-conducteur (14) sont intégrés sur le substrat fait d'InP,
la première couche active contient un matériau à base d'InGaAsP, et la seconde couche active contient un matériau à base d'AlGaInAs.

10. Dispositif laser semi-conducteur intégré (10) selon l'une quelconque des revendications 1 à 9, dans lequel
le laser semi-conducteur (11) a une section à laser à rétroaction distribuée et une section à réflexion de Bragg distribuée,
dans la section à laser à rétroaction distribuée, la première couche active est continue sur une direction de longueur de cavité optique, et une couche à réseau de diffraction est disposée dans le voisinage de la première couche active le long de la première couche active, et
dans la section à réflexion de Bragg distribuée, la première couche active est disposée distinctement et périodiquement pour former un réseau de diffraction.

11. Module laser semi-conducteur, comprenant le dispositif laser semi-conducteur intégré (10) selon l'une quelconque des revendications 1 à 10.
